(19) Europäisches Patentamt
European Patent Office
Office européen des brevets

(11) **EP 4 779 346 A1**

(12) **EUROPEAN PATENT APPLICATION**

(43) Date of publication:
**22.07.2026   Bulletin 2026/30**

(21) Application number: **25151902.1**

(22) Date of filing: **15.01.2025**

(51) International Patent Classification (IPC):
**G01R 33/3873** (2006.01)

(52) Cooperative Patent Classification (CPC):
**G01R 33/3873**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **ESAOTE S.p.A.**
**16152 Genova (IT)**

(72) Inventors:
• **FERRANDO, Fabrizio**
**16154 GENOVA (IT)**
• **PUNZO, Vincenzo**
**80046 San Giorgio a cremano (NA) (IT)**
• **GRILLO, Simone**
**16127 GENOVA (IT)**

(74) Representative: **Karaghiosoff, Giorgio Alessandro**
**c/o Praxi Intellectual Property S.p.A. - Savona**
**Via F. Baracca 1R, 4° piano**
**"Il Gabbiano"**
**17100 Savona (IT)**

(54) **CORRECTING INHOMOGENEITY OF THE STATIC MAGNETIC FIELD GENERATED BY A MAGNETIC STRUCTURE, PARTICULARLY OF THE STATIC MAGNETIC FIELD GENERATED BY THE MAGNETIC STRUCTURE OF AN MRI SYSTEM**

(57)     A method for correcting inhomogeneity of the static magnetic field generated by a magnetic structure, particularly of the static magnetic field generated by the magnetic structure of an MRI system comprising the steps of generating a statistical model of a shimmed magnet structure of the same kind of a target magnet structure to be shimmed, the said statistical model is generated as a function of historical data which describing the features of shimming processes carried out on identical magnets.

The statistical model is used to guide in an objective way choices which the persons carrying out a shimming process are faced with between at least two alternative solutions of a minimization algorithm between the magnetic field having a target homogeneity and e magnetic field of the non-shimmed magnet structure combined with the magnetic field generated by a set of magnetic correction elements.

Also a system is disclosed for carrying out the method.

Fig. 2

EP 4 779 346 A1

**Description**

Technical field

The present application relates to a method for correcting inhomogeneity of the static magnetic field generated by a magnetic structure, particularly of the static magnetic field generated by the magnetic structure of an MRI system.
Furthermore, the present application relates to an MRI system comprising a magnetic structure and configured for carrying out the above method.

Background of the invention

Correction of inhomogeneities of the magnetic field of an MRI magnet structure is currently known under the denomination of shimming.
Current methods for shimming magnetic fields of magnets of MRI apparatuses are based on analytical solutions of equations used to describe the magnetic field generated by a distribution of magnetic material. This kind of approach is relatively long and complex and requests highly specialized service persons. Basing on a polynomial expansion representing the magnetic field, the coefficients of the unskimmed magnetic field are compared with the coefficients of the same expansion function defined for the target magnetic field, namely for a magnetic field having the target homogeneity conditions. The computational process for calculating correction dipoles for shimming the original magnetic field generated only by the magnet is generally based on minimization algorithms which calculates each one of a set of correction dipoles having each one a specific field strength and a specific position relatively to the magnet.
The equations and the solution of the equations allowing to carry out the corrections becomes more and more complex and time consuming with the shape of the gantry and of the ideal surface describing the limits of the imaging volume. Furthermore, the trend goes towards the use of magnetic structures which are very short and also as much as possible open and this worsen the homogeneity conditions of the magnetic field generated by the non-shimmed magnet.
EP0940686A1 discloses a method for correcting and/or calibrating magnetic fields, particularly intended for magnets in nuclear magnetic resonance imaging systems comprising the steps of:

i) generating a polynomial expansion function representing the magnetic field generated by the magnet and comprising a plurality of harmonic terms, each associated to a coefficient;
ii) measuring the magnetic field and sampling it in a plurality of locations, with a predetermined space distribution;
iii) determining the coefficients from the sampled values in the field;
iv) comparing the measured coefficients with those describing the field with the desired characteristics;
v) defining a grid for positioning the correction elements, depending on the magnet structure and on the correlation thereof with the field structure and positioning the grid inside the magnet structure so that the contribution of correction elements positioned on the grid adds to the magnetic field generated by the magnetic structure;
vi) calculating the position and magnitude parameters of said one or more correction elements to obtain the desired field characteristics of the field of the magnetic structure in combination with the contribution of the field of the said one or more correction elements positioned on the said grid;
vii) repeating, if necessary, the sampling operation and the steps ii) to vi) until a target homogeneity condition is achieved.

Generally the process needs more than one repetitions which adds correction elements to the grid so that the process of making the magnetic field homogeneous converges at each step to an optimal solution, at least minimizing the differences between the desired magnetic field as defined by the theoretic computation and the magnetic field effectively resulting from the measurements, or generating a magnetic field which has inhomogeneities lower than a predetermined maximum threshold, typically of the order of some ppm.
Different kinds of parameters for defining the threshold are possible, such as for example peak to peak rates or average rates or standard deviation or other statistical parameters.
In order to carry out the above steps in document EP0940686 the morphology of the sampling volume of the magnetic field is defined;

h) the coefficients of the polynomial expansion which analytically represent the magnetic field are analyzed and subdivided into independent groups, according to the symmetries of the selected reference system and of the relevant harmonic function/s which is/are used in the said analytical description of the magnetic field;
i) the independent groups of coefficients may also be discriminated and ordered according to their belonging to the categories of systematic or asystematic errors, and also in this case in accordance with the symmetries of the magnetic structure and with respect to the selected reference system;

j) the independent groups of coefficients so formed are separately annulled or lowered below a maximum threshold absolute value, following a series of calculation steps, for determining the number, the magnetization distribution and position characteristics of the correction elements with reference to the magnetic structure.

The above steps are generally common to many differently configured shimming methods such as for example the ones disclosed in EP1748300 or US2007229077 or US2014028311.

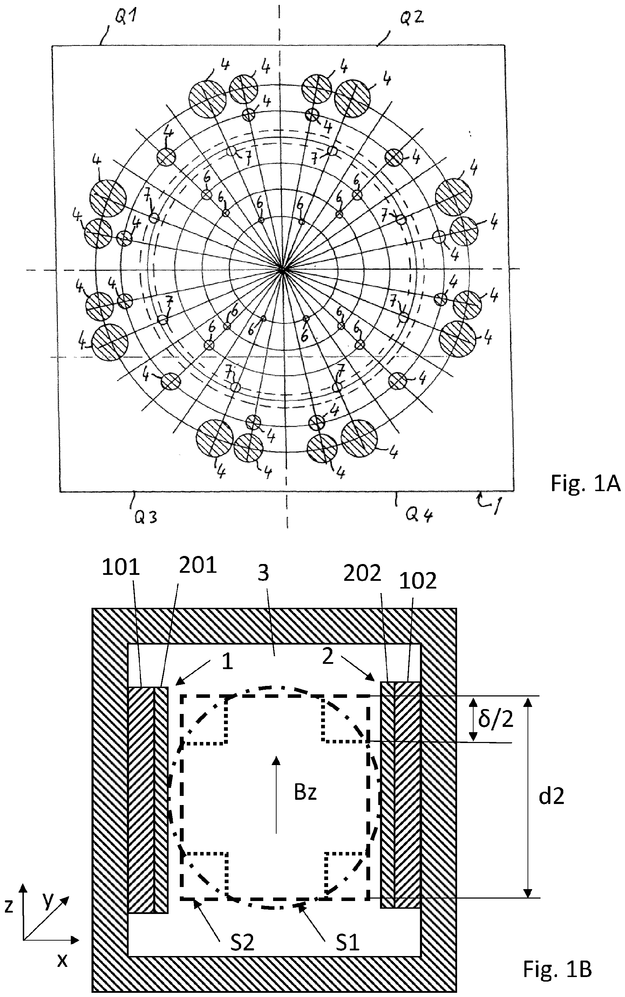

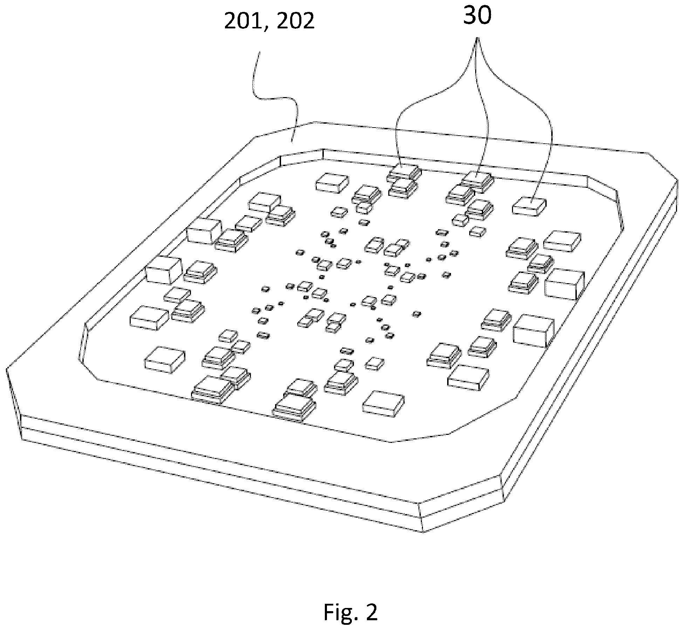

Figure 1 and 2 show examples of the grid associated to a magnetic pole in a magnet structure of an MRI system which are known in the prior art.

Figs. 1A show a distribution of correction elements, obtained through the method according to the invention, and referring to a magnet of the type as shown in fig. 1B, in which two grids are provided each one respectively associated to one of the two opposite poles. Fig. 1B shows a magnetic structure having an annular yoke. It has two opposite poles 1, 2, which delimit a cavity 3 at the top and at the bottom thereof. The poles are associated to members 101, 201 made of a magnetized material, a magnetic field being generated therebetween, mainly in the direction of arrow Bz. The morphology of the sampling volume and the type of harmonics expansion function may be chosen in accordance with the geometry of the magnet and with the designed use thereof. Therefore, fig. 1B shows, by way of example, a spherical volume.

With reference to figure 1A and 1B, on the poles 1 and 2 there is provided an ideal positioning grid, consisting of a sequence of concentric rings, and of an array of radiuses, intersecting them. This defines a grid of positions in angular and radial coordinates. In figure 1A, the hatched elements represent the correction elements for aberrations of the magnetic field Bz are indicated as 4, 6, 7. When a rotational symmetry is supposed for the imaging volume, the number of elements, the positions and the magnetization distribution of the individual correction elements may be determined for a single quadrant of the four quadrants provided Q1, Q2, Q3, Q4 and the distribution of the correction elements provided on a quadrant may be replicated on the other quadrats according to the rotational symmetry. The mathematical description of the grid related to the mathematical description of the field allows to generate an equation system, wherefrom the position on the grid and the magnetization distribution of magnetic dipoles, which form the correction elements 4, may be determined. As a rule, the calculation does not require an optimization procedure consisting in annulling the groups of systematic coefficients, but the number, position and magnetization distribution parameters of the correction elements are determined by lowering said groups of actual coefficients below a predetermined maximum threshold.

In figure 2, a further exemplary embodiment of the distribution of magnetic field correction elements 30 on a tray superimposed to a magnetic pole is shown. The magnetic correction elements are magnetic dipoles having a predetermined magnetic charge. Each magnetic correction element is placed in a certain position on the tray, so that the combined magnetic field of the magnet and of each of the correction elements is a magnetic field for which inhomogeneities are cancelled or reduced below a threshold of few ppm.

AS it will be apparent from the disclosures of the documents cited above carrying out a shimming operation requires both a high specialization in physics and mathematics and good skills in carrying out manual operations requesting very fine adjustments such as the positioning of the correction elements in the right place of the grid.

Currently the operations are carried out by human persons for each magnetic structure and the time requested for executing the shimming task are normally quite long and complex.

As it will appear evident from the above cited documents, the inhomogeneities of the magnetic field have two different origins: Inhomogeneities are introduced by the shape of the magnetic structure and this kind of inhomogeneities or aberrations are considered being of the systematic kind depending on constructive parameters of the magnet structure which are present in every identical magnetic structure; Non-systematic aberrations or inhomogeneities which are due to the tolerances in the dimensional and relative positioning of the constructive elements forming the magnet structure as well as to tolerances of the material used in relation to the magnetic behavior of the said material. The compensation of this kind of inhomogeneities or aberrations cannot be easily predicted since it is specific and may be different for every different magnet structure. On the other hand, since each magnet needs to be subjected to a shimming operation there is a certain number of independent shimming cases for which there are available data relating to the initial magnetic field generated by a magnet which has not yet been subjected to the shimming and corresponding data relating to a certain distribution of correction elements on the positioning grid, which provides a shimmed magnetic field having the desired homogeneity conditions.

Taking into account the symmetries of the field and of the magnetic structure allows, as disclosed above, to reduce the number of variables to process since the grid and the number of correction elements is limited to only one part of the complete grid.

According to the shimming process known from the state of the art, the person carrying out the shimming process operates with the aid of a computer program which at each iteration step indicates to the said person the correction elements to be added on the grid relatively to magnetic field strength and polarity of the said correction elements and to their position. As it may appear clear for the skilled persons there might exist more than one solution resulting from carrying out the above disclosed methods and which solutions leads to essentially identical correction in relation to minimization of the inhomogeneity or in relation to minimization of the differences between the computed and desired magnetic field and the effectively measured magnetic field generated by the said correction. The said different solutions may differentiate one from the other in that each solution comprises a different distribution of correction elements, which distributions may be different relating to the total number of the correction elements and/or the magnetic charge and polarity of each or some of the correction elements and/or the positions on the grid of the said correction elements and/or the geometrical dimensions of the correction elements and/or the total charge of the set of correction elements.

Currently the person carrying out the shimming selects one of the solutions suggested by the program basing this choice on its personal skills and experience acquired in carrying out several shimming processes on several magnets. The result is that the quality of the shimming and also the duration and efforts needed to carry out the shimming process itself are user dependent and that for differently skilled and/or experienced user different solution are obtained so that no exact repetition of the shimming performances is ensured.

In the current practice, a first step carried out before starting the computational process of determining the position and the intensity of the magnetic field of the correction elements, i.e. the magnetic charge and/or the polarity of the magnetic field of the correction elements, consist in the choice of the definition of the existing symmetries and in the choice of one of these symmetries for which the computational process of determining the position and the intensity of the magnetic field of each correction element is carried out in a first processing step. The execution of the shimming process for the further symmetries is carried out in following steps. The correct choice of the symmetry on which the shimming process is carried out at first, is critical for the further prosecution of the shimming process and also for the duration of the process itself, such as for example the total number of steps. A correct choice would in many cases automatically cause that for some further symmetries the shimming process is not anymore necessary.

Since the choice between the alternatives furnished by the program depends mainly on the personal skills it appears very difficult to generate an objective protocol for carrying out the above described choice and which protocol could be based on well-defined rules guiding the person carrying out the shimming process and offering repeatable outcomes independently from the skills of a person in charge of carrying out the shimming process.

In addition to the choice of a symmetry on which the shimming process is carried out at first, many further conditions could and should be considered for choosing the set of correction elements representing the best solution or the best intermediate solution of the optimization process among the different apparently equivalent solutions furnished by the mathematical minimization algorithm. Some examples are disclosed in the following non exhaustive list of examples:

correction elements determined in a following iteration step may have same or very close positions on the grid with correction elements determined in one of the previous repetition steps, determining a concentration of magnetic charge in certain positions;

near or coinciding correction elements may have same polarity so that they cannot be placed in the determined position due to their mutual repulsion;

near or coinciding correction elements may have different strength of the magnetic field but opposed polarity so that these correction elements may be replaced by only one correction element having a charge and polarity resulting from the combination of the charge and polarity of said near or coinciding correction elements;

the solution comprising a set of correction elements to be placed on the grid which total magnetic charge is lower than that of other sets or is the lowest one is preferred to the solutions comprising set of correction elements which total charge is higher than the one of other set of correction elements;

the sets of correction elements which provides a more homogeneous distribution of the charge on the grid are preferred in respect to other sets of correction elements which generate less homogeneous distributions of the charge on the grid.

According to a further aspect of the current practice, and particularly relatively to the field of shimming process of magnetic structures of MRI systems, the number of differently configured magnetic systems is limited to a certain limited number of configurations. Thus, shimming is carried out on only some different configurations of magnetic structures and there is a certain number of shimming processes carried out on the same configuration of magnetic structure which is common to a plurality of MRI apparatuses. This is the case for example relatively to the different models or series of MRI systems produced by a company and which models are produced in a certain number of pieces and have the same or essentially the same magnetic structure.

Basing on this fact it has been experimented to use machine learning models which helps to make use in a more objective way of the experience gathered by the human operators skilled in carrying out the shimming processes, thus overcoming the limitations of relying only on the personal ability of the person carrying out the shimming process. Experiments has shown that the fitness of this approach based on the machine learning algorithm trained on the data available from shimming processes already carried out by human operators using the traditional tools was not of satisfactions. Indeed, the said non satisfying fitness and reliability of the results obtained by using machine learning algorithms is due to the fact that the number of a certain type of magnetic structure effectively produced and submitted to shimming is not so high to ensure a sufficient number of independent cases in order to correctly train a machine learning algorithm. Attempts to synthetically increase the number of the training records by applying, in combination with the algorithm used for determining the set of shimming correction elements, further machine learning algorithms dedicated to the generation of said synthetic training records, such as for example generative algorithms, genetic algorithms or carrying out domain adaptation of training records relating to differently configured magnetic structures, have not been sufficiently reliable in providing a good fitness of the distribution of correction elements needed to cause a good quality of the shimming.

In order to simplify the wording in the following description and in the claims, the term "charge" is used to indicate the strength of the magnetic dipole field of a correction element. In addition, the orientation of the correction elements relatively to the position of the two poles generating the magnetic dipole field is defined as "polarity" of the correction element and the two poles being identified by the sign (-) or (+). Thus, according to the above definitions, a correction element has a certain charge corresponding to a certain strength of the magnetic dipole field generated and the charge has a certain sign (-) or (+) depending on whichone of the two poles of the correction dipole is oriented facing the positioning grid.

Brief disclosure of the invention

It is an object of the present invention to provide a method for carrying out the shimming of a magnet of an MRI apparatus in a simpler and less time consuming way allowing to obtain at least the same precision in suppressing or reducing the inhomogeneities of the magnetic field as for the current methods but in less of the time currently needed.

It is a further object of the present invention to allow the shimming process to converge more rapidly to an optimum solution comprising the lowest total magnetic charge of the correction elements determined and/or to a solution in which the distribution of the magnetic charges avoids concentrations of this magnetic charges only on some of the correction elements and/or essentially in only some regions of the grid and/or also the distribution of the positions of the correction elements on the grid is more homogenous.

A further object of the present invention is to provide for a method for shimming magnets which allows to exploit in a most effective way the experiences gathered in previous shimming processes carried out successfully by human operators and/or also by previous methods based on machine learning algorithms.

In relation to the above aspect, the present invention also aims to develop a shimming process and a shimming system which ensure high performances in relation to the convergence to the optimum outcome of the shimming process with a limited computational burden in terms of computational power, electric power consumption and/or duration of the computational steps.

According to a general embodiment of the present invention there is provided a method comprising the following steps:

i) defining a criterion for evaluating the homogeneity of a magnetic field by at least one parameter describing the said homogeneity of a magnetic field generated by a magnet structure having a predefined shape and/or a predefined distribution of units generating the magnetic field and setting at least one threshold value of the said at least one parameter which is describing a target homogeneity of the said magnetic field;

ii) selecting an harmonic, spherical or spheroidal expansion representing the magnetic field generated by a magnet to be shimmed and comprising a plurality of harmonic terms, each associated to a coefficient;

iii) defining a grid for positioning correction elements, depending on the shape of the magnet structure and/or of the magnetic field generated by said magnet structure;

iv) carrying out a shimming process comprising the steps of:

v) measuring the magnetic field and sampling it at a plurality of locations, which are defined according to a predetermined spatial distribution pattern;

vi) determining the coefficients of the said harmonic spherical or spheroidal expansion function representing the magnetic field from the said measured sample values of the magnetic field;

vii) determining at least one or more sets of correction elements comprising one or more magnetic field correction dipoles each one producing a magnetic dipole field of a determined strength and thus having a determined charge and a determined sign or polarity, and each of the said correction elements being associated to a calculated position of it on the said grid, by carrying out a minimization algorithm of the differences between the coefficients of the said harmonic expansion calculated from the measured values of the magnetic field at step iv) and of the coefficients of the said harmonic expansion calculated for the target magnetic field having said target homogeneity condition,

the said minimization algorithm providing at least two different and alternative sets of correction dipoles relatively to the charge and/or the sign and/or the position on the positioning grid of the corresponding correction dipoles and which at least two different sets of correction dipoles generates a corrected magnetic field at least approaching the target homogeneity condition;

viii) selecting one set of correction dipoles of the at least two different sets of correction dipoles calculated according to step vi);

ix) at least theoretically evaluating the effects of the said set of correction dipoles on the homogeneity of a corrected magnetic field which is the magnetic field generated by the magnetic structure and the said set of correction dipoles having each a calculated charge, a calculated polarity and a calculated position on the said grid, by determining if the value of the homogeneity of the said corrected magnetic field is at least approaching or getting away from the said target homogeneity condition defined at step i);

x) repeating, if necessary, the sampling operation and the steps iv) to viii) and adding for each iteration the respectively calculated correction dipoles to the ones calculated for previous iteration steps till a corrected magnetic field is generated for which said target homogeneity condition is achieved within predefined tolerances;

xi) the choice of step viii) of selecting a set of correction dipoles calculated according to step vii) among the said one or at least two sets of correction dipoles is carried out by providing a classification model for evaluating the quality of the selected set of correction dipoles in generating a corrected magnetic field which is at least approaching the target homogeneity;

said classification model being used to classify according to at least two quality classes the sets of correction dipoles calculated at each iteration of the said processing steps of said shimming process or to predict the quality class to which the said sets of correction dipoles belong among at least two predefined quality classes,
the said at least two quality classes are discriminated by

the effect on the homogeneity of the magnetic field generated by the magnet to be shimmed in combination with the said set of correction dipoles placed on the grid and which correction dipoles have a calculated charge, a calculated polarity and a calculated position on the positioning grid
the said effect relating to approaching to said target homogeneity condition or in getting away from the said target homogeneity condition evaluated by the said homogeneity criterion defined at step i),
and the said at least two quality classes being determined by classifying on at least two quality clusters the set of correction elements calculated at an iteration step of the shimming process,
each one of the said clusters representing a quality class of sets of correction elements determined in each iteration step of shimming processes carried out for identical or equivalent magnetic structures and memorized in a ground truth knowledge base,
the said at least two clusters collecting respectively in a first one of the said at least two clusters, data of a processing step, which has generated a set of correction elements which at least do not cause a getting away of the corresponding corrected magnetic field from said target homogeneity condition or have caused an approaching to the said target homogeneity condition and, in a second of the said two clusters, a set correction elements which has caused a getting away of the corrected magnetic field from the said target homogeneity condition.

According to an embodiment, the first of the said quality cluster described above is labeled as "positive" and the second of the said quality clusters described above is labeled as "negative".

As it appears clearly from the above features the generic embodiment of the method for shimming magnets according to the present invention, makes it possible to consider the historical data of the shimming processes carried out in the past on similar or identical magnetic structures by using shimming methods according to the state of the art.

As already indicated above, these state of the art methods are strongly dependent on the personal skills of the operators in selecting alternatives solution furnished by carrying out the minimization algorithm and which solutions are apparently equivalent one to the other in relation to satisfying the predetermined target homogeneity conditions.

The present shimming method, conversely, allows the operator to make use of a guiding tool in carrying out the selections to be met in relation to the shimming strategy and the selection for each iteration step of the shimming process of the best or more effective solution among a plurality of apparently equivalent solutions furnished by the algorithm used for calculating the sets of correction elements to be positioned on the grid. Indeed, this guidance tools provides for coding in an objective manner and by repeatable mathematical tools a combination of independent parameters relevant for describing the features of each of the iteration steps of the shimming process recorded in historical shimming data, thereby fixing personal experience of more or less skilled operators in the shimming of magnets in an objective knowledge database.

Carrying out the step of using the data related to the iteration steps of historical shimming processes in this coded form allows for generating classification clusters in which the data coded by the said combination of predetermined parameters relating to each iteration step are grouped according to quality labels relating to the effectiveness of the calculated correction dipoles respectively in at least approaching the homogeneity target condition or in at least not getting away from it or even in getting away from it. This objective knowledgebase can also be upgraded by adding to the clustered data, the data of the coding parameters of the iteration steps determined during each new shimming processes.

Furthermore, as it will appear more clearly in the following description, the knowledgebase comprising the said historical data, also called truth data, may be exploited with a high degree of effectiveness and fitness also if the number of available records is not sufficient for ensuring the use of more traditional classification algorithms based on machine learning algorithms which are configured to directly determine a best set of correction dipoles from historical training data and which would need a greater number of independent records for being trained in such a way to ensure high fitness and high reliability of the output.

In a more generic definition of the method according to the invention the evaluation of the quality of the effectiveness of a certain set of correction dipoles in achieving or in at least approaching the target homogeneity of magnetic field corrected by the said sets of correction dipoles may be directly related to the features of the correction dipoles of the said set of correction dipoles, namely at least the charge and/or the sign of the charge and/or the position on the grid. Nevertheless using as a mathematical representation tool, such as an harmonic expansion, for representing the measured magnetic field of the magnet, the magnetic field having the target homogeneity and the corrected magnetic field generated by the magnetic field of the magnet combined with the magnetic fields of the correction dipoles, the minimization algorithm may be carried out as a function of differences of the coefficients of the harmonic expansions related to the said magnetic fields, the calculation of the charges, and or of the signs and/or of the positions of the correction dipoles being a function of the said minimization of the said coefficients.

According to a variant embodiment, the physical positioning of the correction dipoles determined at each iteration of the steps of the shimming process may not be carried out concretely, but at least for one or more of the iterations of the steps of the shimming process, the effects of the set of correction dipoles calculated at each of the said one or more iteration steps on the effectively measured magnetic field of the magnet or of the effectively measured corrected magnetic field for one or more preceding iterations of the shimming process, may be calculated theoretically instead of concretely placing on the positioning grid the correction elements calculated by each of the said one or more iteration steps. After having carried out the above steps in a theoretical or virtual manner as disclosed for the said one or more iteration steps, and having theoretically achieved a corrected magnetic field having target homogeneity within predefined tolerances, the process of effectively placing the said sets of correction dipoles on the positioning grid may be carried out for all correction dipoles calculated at the said one or more iteration steps or calculated as the final set of correction elements in order to effectively measure if the target homogeneity condition has effectively been achieved within the predefined tolerances.

The above step viii) of selecting one set of correction elements is caused by the fact that applying a minimization algorithm at step vi) this algorithm generally produces a certain number of alternative solutions each consisting in a more or less different set of correction dipoles. The differences of the said alternative sets may consist in the total number of the said correction dipoles in a set and/or the charge and/or the sign of each or at least some of the said correction dipoles of the set and/or the position on the positioning grid for at least some of the said correction dipoles of the set. These alternative sets of correction dipoles determined at one iterative step appears all to solve the minimization algorithm, but may have a strong influence on the following iteration steps relatively to the total number of steps needed to satisfy the said homogeneity criterion and other conditions which influence the quality of the shimmed magnet further to the mere satisfaction of the quality degree of homogeneity of the magnetic field strength along the pole surfaces of the magnet and which further features used for selecting the optimum set of alternative correction elements will be disclosed in the following description in more detailed manner.

According to preferred improvement of the shimming method, the kind of magnetic structure and the harmonic expansion of the magnetic field generated by it are analyzed for identifying a certain number of different symmetries that may be present.

For example, in magnets having a circular surface as an interface between the magnetic pole of the magnet and a volume of space permeated by the magnetic field and on which surface a positioning grid of the correction dipoles according to the above-described example of figure 1 is placed, eight different sections of symmetries can be identified which in relation to the harmonic expansion selected at the above disclosed step ii) can be defined as:

    1. DDC (odd odd cosine)
    2. DDS (odd odd sine)
    3. DPC (odd even cosine)
    4. DPS (odd even sine)
    5. PDC (even odd cosine)
    6. PDS (even odd sine)
    7. PPC (even even cosine)
    8. PPS (even sine).

In an embodiment of the above method, prior to carrying out the step vii) the method provides the additional step of choosing one of the said symmetry sections as a starting symmetry section on which carrying out the iterative steps of the said shimming process by considering the coefficients of the said harmonic expansion function belonging to the said chosen symmetry section, the steps of the shimming process being iteratively repeated till the said target homogeneity condition has been achieved within the said symmetry section, while after having terminated the shimming process on said first symmetry section, the iterations of the steps of the shimming process are carried out in sequence on each of the further symmetry sections identified by considering the coefficients of the harmonic expansion belonging to each of the said further symmetry sections and the said target homogeneity condition.

The sequence of symmetry sections in carrying out the shimming process may be random or may be defined according to a certain order.

According to a further feature of the method according to one or more of the above mentioned alternative embodiments there are provided different target homogeneity conditions for some or all of the said symmetry sections defined by the harmonic expansion.

As an example, related to the above disclosed symmetry sections associated with the circular magnetic poles and/or circular positioning grids of the correction dipoles, the tolerances relating to the target homogeneity condition for the ppc symmetry section may be chosen to be:

| Coefficient of the harmonic expansion | Threshold of target homogeneity |
| --- | --- |
| Coeff(8,0) cosine | < 20ppm in v.a. |
| Coeff(10,0) cosine | < 30ppm in v.a. |
| Coeff(12,0) cosine | < 75ppm in v.a. |

For all the other coefficients the threshold of the target homogeneity condition is < 10ppm in v.a..

According to the above additional steps of identifying the symmetry sections of the magnetic structure subjected to shimming and the corresponding coefficients of the harmonic expansion function describing the magnetic field generated by the said magnet structure, selecting a starting symmetry section for carrying out a first cycle of iterations of the shimming process and setting a sequence of carrying out the said iteration steps of the shimming process on at least one or more or of all of the further symmetry sections present for the magnetic structure subjected to shimming, the operator is faced with the problem of selecting the starting symmetry section and/or the said sequence of the said further symmetry sections which are most promising or most effective in making the shimming process converge more rapidly to the one or more target homogeneity conditions and in providing the best distribution of correction dipoles and also in defining the most promising sequence of symmetry sections on which carrying out the shimming process.

According to the present shimming method one or more of the above disclosed embodiments can be combined with a starting symmetry sections selecting step and with a definition step of the sequence of the one or more of the further symmetry sections which steps comprise:

    providing a classification model of the selectable symmetry sections as starting symmetry section according to the effectiveness in approaching to said target homogeneity condition or in getting away from the said target homogeneity condition and
    in defining a sequence of the remaining one or more symmetry sections on which carrying out the iteration steps of the shimming process;
    classifying the symmetry sections individuated for the magnet structure which must be shimmed according to the said classification model and using the starting symmetry section and the sequence of the remaining one or more symmetry sections on which carrying out the iteration steps of the shimming process determined by the said classification step,
    the said classification step using a classification model being generated by classifying and/or clustering relatively to their effectiveness in approaching to or getting away from a target homogeneity condition provided for the said symmetry sections, the data related to the selection of starting symmetry sections and the data related to the sequences of the one or more remaining symmetry sections taken by the operator in the shimming processes carried out in the past (historical data) on similar or preferably identical magnets and saved in a database of symmetry selection records.

In this way, the personal experience gathered by human operators which have carried out shimming processes of several magnetic structures of one kind of magnetic structure can be coded in a specific data record for each shimming case and made available with an objective method for the processing of further cases. Without being a limiting indication, the specific data of the data record of the database used for carrying out the clustering may comprise for example the coefficients of the harmonic expansion calculated as a function of the measured sample data of the magnetic field of the non-shimmed magnet and of all the coefficients of the harmonic expansions related to the corrected magnetic field resulting at each iteration step of the process and/or the data of the one or more sets of correction dipoles calculated at each step. Further variables may comprise the number of iteration as well as the starting symmetry which has been chosen and/or the sequence of the further symmetries which are available for the case.

According to a further embodiment of the present shimming method according to one or more of the preceding embodiments and/or features, a further step may be provided before carrying out the steps of the shimming process and/or of a starting symmetry selection and optionally of the determination of said sequence of symmetry sections selected after carrying out the shimming process using the selected starting symmetry section, in which further step the total number of correction dipoles which has to be used for carrying out the shimming process is set.

According to a further feature which can be provided in any combination with one or more of the embodiments disclosed above, a further step may be provided before carrying out the steps of the shimming process and/or of a starting symmetry selection and optionally of the said sequence of symmetries selected after carrying out the shimming process using the selected starting symmetry section, in which further step the number of free positions is determined which positions are available on the gird for positioning the correction dipoles, resulting from one or more of the iterations of the shimming process carried out for one or more or all the symmetry sections available form the harmonic expansion and for each iteration step of the shimming process according to one or more of the preceding embodiments.

For each iteration step of the shimming process according to one or more of the preceding embodiments the algorithm my provide a certain number of different combinations of position and magnetic charge of the correction dipoles which can be equivalent one to the other when considering only the said homogeneity criterion. Thus, according to a further feature of the present shimming method which can be provided in any combination with one or more of the embodiments or features disclosed above for the present shimming method, the additional steps may be provided consisting of:

defining a limit of the magnetic charge for each or at least each of some of the correction dipoles and/or
defining a limit of the total charge of the correction dipoles calculated by an iteration step of the shimming process, and
excluding each combination of correction dipoles determined in carrying out each iteration step of the shimming process and/or for each selected symmetry section overcoming the said limits and
choosing the said combination of the said correction dipoles for which the said total charge is the lowest.

According to a further feature of the shimming method which further feature can be provided in combination with any of the one or more embodiments and/or different features of the shimming method disclosed above, the said shimming method provides also the additional step of allowing the operator to observe the positions calculated for each combination of correction dipoles on the grid and to discard those combinations of correction dipoles for which the corresponding positions on the grid may be more complex than for other combinations of correction dipoles or for which combination the position of at least one or more of the correction dipoles may interfere physically or magnetically with the position and/or the magnetic field of correction dipoles already present on the said positioning grid.

According to a variant embodiment of the above additional step, the shimming process may provide for the steps of generating a virtual image of the positioning grid and of the correction dipoles and of displaying on a monitor the said virtual image by showing the position of correction elements already placed on the grid by executing preceding iteration steps of the shimming process and also showing the positions of each of the correction elements determined in the current iteration step of the shimming process.

Optionally the correction elements may be differentiated one from the other relating to their physical dimensions and/or to the charge and/or to the polarity, meaning the sign of the said magnetic charge, by using differentiating graphic features such as dimensions of the image reproducing a correction dipole, and/or a color, while the operator is allowed to select one or more images of the correction elements and displace them onto different positions of the grid and/or change the strength or polarity of the magnetic field and/or discard one or more correction elements from the image of the positioning grid, while a feedback of one or more of these actions modifying the number and/or position and/or the charge and/or the polarity and/or the position of the said one or more correction dipoles is provided on the effects on the coefficients of the expansion and/or on the classification relating to the quality of the effects on the homogeneity.

Different alternative classification models can be provided for carrying out the steps of the shimming method according to one or more of the embodiments disclosed above. As already disclosed, the different methods all rely on an analysis of the historical data related to the shimming processes carried out on similar or identical magnets and which data is available as a ground truth database to processing and which data is needed in order to identify and define the said predetermined number of parameters needed to univocally define the features of each iteration step of the shimming process and to generate a parametric coding of the data of the said iteration steps of the shimming process which helps in making the said coded data comparable one to the other.

The data related to the historical shimming processes are coded by defining one or more independent parameters describing characteristic features of the said historical data. Different classification models can be generated basing on this coding parameters. These models are configured for carrying out the above disclosed steps of selecting at each iteration step the most effective set of correction dipoles and/or the most effective starting symmetry section and/or the most effective sequence of symmetry sections on which the shimming process is to be carried out, said effectiveness being related to the approaching of a corresponding iteration step of the shimming process to the target homogeneity condition.

According to one embodiment the classification model comprises a machine learning algorithm or a combination of machine learning algorithms which is/are configured to work as a classification algorithm, such as one neural network or a combination of neural networks and for which algorithms the input data consists in the variables representing the parameters coding the data of the iteration steps of the shimming process such as the number, the charge, the sign of the charge and the position of correction dipoles calculated at each iteration step of the shimming process, the total charge of the correction dipoles and/or the corresponding coefficients minimizing the differences between the effectively generated magnetic field and the theoretically expected target magnetic field in relation to the target homogeneity, and/or the symmetry for which the said correction dipoles and the said coefficients are calculated. The output data consisting in clusters in which the data of an iteration step of the shimming process coded by the parameters represented by said input variables are grouped according to the effectiveness in achieving or at least approaching more or less the target homogeneity by the corrected magnetic field.

According to a further embodiment, the classification model is a so called statistical parametric model, which comprises a parametric metric function considering predetermined parameters describing features of data available form an historical database for generating clusters of data showing the same or similar features. In an embodiment of the present case the said features are the quality features of the set of correction dipoles and/or of the coefficients of the harmonic expansion calculated at each iteration of step of the shimming process by carrying out the minimization algorithm in relation to the effectiveness in approaching and/or in getting away from the target homogeneity condition and/or the features of effectiveness in approaching to or getting away from a predetermined target homogeneity condition of the selection of the starting symmetry sections and/or of the sequence of the remaining symmetry sections for which carrying out the steps of the shimming process. The said parametric function being used for evaluating the said quality and effectiveness features of the selection of a calculated combination of correction dipoles for each iteration step and/or for each selection of the starting symmetry section and of the said sequence of the one or more remaining symmetry sections which evaluation is an objective guide for the operator to make a certain selection.

According to still a further alternative, the said classification model includes a clustering algorithm such as for example a k-means clustering algorithm which based on a parametric metric function determines clusters of data related to the quality of specific combination of correction dipoles and/or the effectiveness of the choice of a starting symmetry section on which carrying out at first the shimming process and/or of the sequence of the one or more remaining symmetry sections on which the said shimming process has to be carried out and/or the coefficients of an expansion resulting from a minimization step of an iteration step of the shimming process.

According to a further aspect, each of the above mentioned alternatives is based on providing a database of historical data related to shimming processes carried out on similar or identical magnets structures and in defining a combination of parameters which univocally describes the said historical data in relation to the effects on the approaching to and/or getting away from a target homogeneity condition for each iteration step of the shimming method, as for example the steps vi) to xi) and/or the setting of the starting symmetry section and of the sequence of execution of the shimming steps on each of the one or more remaining symmetry sections.

According to the above mentioned further aspect the available data is coded by considering different parameters which are grouped in records, expansions and reports.

According to a feature of the present shimming method, the data defined as records is coded by eight variables describing an ith-step of iteration of the shimming process, for example according to the steps vi) to xi).

In an embodiment, the said eight variables consists in:

an array with the coefficients of the selected symmetry section at a preceding step, step i-th of iteration;
an array with the coefficients of the selected symmetry section at a following step, step ith+1 of iteration;
theoretical variation of the coefficients generated by considering the effects on the magnetic field of the correction dipoles virtually positioned at the corresponding positions on the positioning grid;
experimentally measured variation of the coefficients generated by measuring the effects on the magnetic field of the correction dipoles effectively and concretely positioned at the corresponding positions on the positioning grid;
order number of the preceding iteration step;
order number of the following iteration step;
a matrix comprising the magnetic field strength of the correction dipoles, the polarity and the corresponding position on the positioning grid of the correction dipoles positioned theoretically or concretely on the grid;
the selected symmetry section for which the iteration steps of the shimming process are carried out.

The classification model determines the data of the array with the coefficients of the selected symmetry section at a following step, step ith+1 of iteration, by adding to the said array with the coefficients of the selected symmetry section at a preceding step, step i-th of iteration, the theoretical variation of the coefficients generated by considering the effects on the magnetic field of the correction dipoles virtually positioned at the corresponding positions on the positioning grid.

Experimental results can be obtained by adding to the said array with the coefficients of the selected symmetry section at a preceding step, step i-th of iteration, the experimentally measured variation of the coefficients generated by measuring the effects on the magnetic field of the correction dipoles effectively and concretely positioned at the corresponding positions on the positioning grid.

The data related to the expansions are coded by parameters consisting in the coefficients of the complete harmonic expansion of the field of a magnet at a certain iteration step of the shimming process. According to a variant embodiment, the said coefficients are expressed in terms of the coefficients of a corresponding Fourier series.

According to an embodiment, the coefficients of the complete expansion function describing the magnetic field may be ordered in a tabular form comprising columns related to the two indices (1, m) of the expansion and columns related to the cosine and the sine basic functions which contains the values of the coefficients of the expansion.

In relation to the above features, for each harmonic expansion representing the magnetic field it is possible to extract from the said table the coefficients related to each of the symmetry sections available and which corresponds to the array of coefficients defined in the combination of parameters coding the records. This can be done by a filtering function setting the values for the first and second indices (1, m) corresponding respectively to the symmetries even and odd and extracting the data of the coefficients in the column corresponding to one of the basic functions such as sine or cosine. For example, for the symmetry section identified above as PPC the said indices starts from the values which is l=2 and m=0.

In relation to the parameters labeled as reports, these parameters relates to the positions on the positioning grid of the correction dipoles calculated by the algorithm and relates to the above disclosed further choices made by the operator in relation to the historical shimming processes, the said choices being the total number of correction dipoles to be placed on the grid depending on geometric constraints such as the number and positions of correction dipoles already placed on the positioning grid in previous iterations of the shimming process, and/or changes in the strength of the magnetic dipole field and/or placing a lower number of correction dipoles as calculated by the algorithms and in this case optionally selecting which of the correction dipoles will not be positioned on the grid, also these choices being met by the operator relying on its practical experience and skills in carrying out shimming of magnets.

Further optimization steps may be provided for generating the dataset comprising data describing the shimming steps which are coded by the above-mentioned groups of parameters. These further optimization steps may comprise one or more of the following steps:

> Elimination of duplicated or n-tuplicated records;
> Combining the coded data relating to the label records with the corresponding coded data labeled expansion;
> Eliminating every record comprising coded data for which no expansion data is available;
> Extracting the data coding the further symmetries from the expansion data.

The above data set comprising the said coding parameter groups according to the above description is used for carrying out a definition of the said at least two quality classes relatively to the effectiveness of a shimming iteration step, such as the steps vi) to x) and to one or more of any of the above disclosed variants, embodiments and features. The said quality classes can also be extended to three by considering as an independent quality class the coded data of the iteration steps of historical shimming processes which have no positive nor negative effect relating to the approaching to the target homogeneity condition of the shimmed magnet.

One way of generating the said classes is by carrying out clustering of the said coded data of the dataset generated from the historical data of the shimming processes. Clustering may be carried out by different clustering algorithm which are part of the basic technical knowledge of the skilled person.

The said quality classes are used to classify the output of each one or part of the iteration steps of the shimming process carried out on a new magnet similar or identical to the magnets for which the historical data of the shimming process has been used to generated the said quality classes.

According to the different alternative methods relating to the classification of the quality of the outputs of the one or more iteration steps of the shimming process disclosed above the classification can be carried out by generating a statistical parametric classification model which uses a parametric metric.

According to an embodiment of the classification step, the said classification may be carried out by generating different classification models independently for the parameter coding the data labeled above as records and/or for the selection of the starting symmetry section and of the sequence of the further symmetries and/or classification models for the choices related to the correction dipoles which data has been labeled above as reports.

In relation to the classification of the data of the iteration steps of the shimming process defined above as records, considering the target homogeneity condition and tolerance, the following values for each iteration step of the shimming process relating to a prevoius (i-th) iteration step and to a following ((i+1)-th) iteration step:

1. For the coefficients related to a symmetry:

> a) The average value of the coefficients which generates a magnetic field having a homogeneity condition above the target condition;

b) The percentage of coefficients which generates a magnetic field having a homogeneity condition below the target condition;

2. For the expansion coefficients

a) The average value of the coefficients which generates a magnetic field having a homogeneity condition above the target condition;
b) The percentage of coefficients which generates a magnetic field having a homogeneity condition below the target condition;

3. The above values are determined for the an i-th iteration step and an i-1th iteration step and are compared, whereas:

- It is considered that there is an improvement of the homogeneity condition toward the target homogeneity condition if the above determined values determined at steps 1a.) and 2a.) decrease and/or the values determined at steps 1b.) and 2b.) increase;
- It is considered that there is a worsening of the homogeneity condition relatively to the target homogeneity condition if the values determined at steps 1a.) and 2a.) increase and/or the values determined at steps 1b.) and 2b.) decrease.

The combination of improvement/worsening of the four identified values leads to the creation of sixteen different classification qualities for each step which are reduced into seven stratification classes which may be labeled as: very_good, good, good_coeff, doubt, neutral, bad, very_bad. In the positive classes at least two of the above defined values are improved (for example, in the good_coeff class the values of the coefficients of the selected symmetry are improved), otherwise they are classified as neutral or negative steps. Despite furnishing good results and improving the shimming methods according to the state of the art in the direction of the different aspects described above, this embodiment of parametric metric, has some limits which resides in the fact that the number of comparisons to be carried out is high and also the number of possible classes is high. The choice of the limited number of seven classes is arbitrary and thus introduces some non-objective criteria of the classification. Furthermore, it does not consider the percentage improvement of the first steps, not considering the percentage change in decrease of coefficients but only their value before and after each shimming step, the variation percentage being significant in the first steps. Furthermore, it does not take into account the coefficients, which are compared not individually but with an aggregate measure and the data coding the expansion does not exactly match the symmetry coefficients.

An alternative metric function can be used for classification of the quality of an iteration step of the shimming process which metric is a function of the coefficients of a symmetry section selected for carrying out an iteration step and which coefficients are the one of a previous (i-th) iteration step and of a following (i+1-th) iteration step. Considering the target homogeneity condition and tolerance, the percentage changes of each coefficient of the said symmetry are calculated for each iteration step of the shimming process relating on the coefficients of a previous (i-th) iteration step and on the coefficients of a following ((i+1)-th) iteration step and to the said coefficients weights are applied which takes into account the way of the said changes defined by the following four cases:

- Case 1: the coefficient remains above specification (neutral)
- Case 2: the coefficient before is above and after is below the specification (improvement)
- Case 3: the coefficient before is below and after is above the specification (worsening)
- Case 4: the coefficient remains below specification (neutral).

Further weights may be applied to the said coefficients which are due to the order of the said coefficients and which are inversely proportional to the index order.

Classification is carried out by considering the values of the metric function and the results are classified as "positive", "neutral" or "negative" using two threshold values by applying standard algorithms.

This second embodiment of a parametric metric for a classification model provides improved results, but on the other hand there are many weights to be considered and set. Furthermore, only the coefficients related to the symmetry subjected to the shimming process are considered and not each one of the coefficients of the complete expansion.

According to an embodiment the above metric can be expressed by considering the parameters describing the effects of a shimming step on the coefficients.

The above generic feature cha be described in a more precise manner by a metric defined by the following formula, in which the index i relates to the ith iteration step:

$$\sum_i Weight\_pos_i \frac{\frac{sign(Cpre_i, C\,post_i)*(Cpost_i - Cpre_i)|Cpost_i - Cpre_i|}{Cpre_i} * Specific\,weights_i}{(\sum Weight\_pos_i)}$$

In the above formula the following definitions are set:

$Cpost_i$ are the coefficients after the i-th iteration step has been carried out;
$Cpre_i$ are the coefficients before the i-th iteration step has been carried out;

The term Specificweights relates to four parameters defined in the following as [A, B, C, D] which indicates the relation of the coefficients $Cpre_i$ and $Cpos_i$ relatively to a target value of the said coefficients and in which:

Parameter A indicates that the value of the coefficient remains above the target value corresponding to a quality of the iteration step labeled as neutral;
Parameter B indicates that the that the value of a coefficient $Cpre_i$ is above the target value and the value of the same coefficient at the following iteration step $Cpos_i$ is below the said target value corresponding to a quality of the iteration step labeled as better;
Parameter C indicates that the that the value of a coefficient Cprei is below the target value and the value of the same coefficient at the following iteration step Cposi is above the said target value corresponding to a quality of the iteration step labeled as worse;
Parameter D indicates that the value of the coefficient remains below the target value corresponding to a quality of the iteration step labeled as neutral;
$Weight\_pos_i$ are weights of the coefficients at the i-th iteration step which indicates the position of the coefficient in the expansion and which weights are set as:

Value 1 if the coefficients are constant or are descending with the position according to a linear function.
Sign is a function considering the variation of the sign of the values of the coefficients.

In relation to the embodiment in which a step of suggesting to the operator a starting symmetry among the possible symmetries for carrying out the shimming process separately and in sequence using the coefficients related to each of the said symmetries, the classification model of the selection of the starting symmetry and of the sequence of the further symmetries disclosed above can be further specified by the steps of:
clustering the historical data relating to the symmetry selections of starting symmetry and sequence of further symmetries of shimming processes carried out in the past on at least similar or identical magnetic structures as the one to be subjected to a shimming process, said clustering being carried out by means of a statistic clustering method comprising the following steps:

determining from a complete expansion function describing the magnetic field related to one or more historical data of shimming processes carried out in the past the existing symmetry sections;
calculating the mean values of the coefficients of the expansion for each of the said symmetries;
calculating the median of the vectors of the means for each symmetry;
statistical division of the parametric data relating to the data of the historical shimming processes labeled as records and according to the above disclosed definition on a predetermined number of cluster basing on the comparison of the means of the symmetries in relation to the median calculated at the preceding step;
generating a statistical model for determining the selection of a starting symmetry among the possible symmetries provided for the magnetic field of the magnetic structure to be shimmed and its expansion and for determining the sequence of the further symmetries on which the shimming process has to be separately carried out,
the said statistical model being applied by carrying out the steps of
selecting a cluster of the data labeled as records according to the above definition, preferably a cluster comprising a higher number of said records in comparison to the other clusters,;
applying one of the metric defined above, preferably the metric defined by the formula

$$\sum_i Weight\_pos_i \frac{\frac{sign(Cpre_i, C\,post_i) * (Cpost_i - Cpre_i)|Cpost_i - Cpre_i|}{Cpre_i} * Specific\,weights_i}{(\sum Weight\_pos_i)}$$

For classifying the quality according to the above defined parameters describing the specific_Weighs defined above;

Calculating the percentage of the records labeled whose coefficients are labeled as better, neutral or worse and

Defining as the suggested or most promising starting symmetry the symmetry for which the percentage of coefficients having the quality better according to the above metric is higher and/or

Defining the order of the symmetries of the sequence of the further symmetries on which to carry out the shimming process by selecting the symmetries having progressively lower percentage of records having the quality defined as "better" according to the above metric.

According to a further embodiment, the above method steps regarding to the suggestion of the selection of a starting symmetry section and the above mentioned statistical parametric metric according to the above disclosed formula can be combined with a statistical model for classifying the shimming results in relation to the strength of the magnetic dipole field of each correction dipole and of the position on the grid of the said correction dipoles according to a selection of the strength of the magnetic dipole fields (magnetic charges) attributed to each correction element and to the corresponding position on the positioning grid which is based on the quality of the said selection relatively to the approaching to the target homogeneity, neither approaching nor getting away from the said target homogeneity and getting away from the said target homogeneity and wherein the following steps are provided:

- clustering each of the correction elements relating to the data of the historical shimming processes and in each of the iterations of the shimming process in a predefined number of clusters;
- dividing the different charges of the correction dipoles in each of the said clusters relatively to groups of correction dipoles having different qualities of determining an approaching to the above defined homogeneity target, providing no variation in relation to approaching or getting away from the target homogeneity, and getting away from the target homogeneity;
- applying the statistical parametric metric according to the above formula for selecting the starting symmetry and the sequence of further symmetries;
- Calculating the percentage of the quality of the coefficients of the iteration within each symmetry relating to the quality labeled with "good", "neural" and "negative" associated to the percentage of improvement in approaching the target homogeneity due to the selection of the group of charges or of groups of charges to be used for each correction element and its position on the positioning grid.

The present invention is also directed to a system for correcting inhomogeneity of the static magnetic field generated by a magnetic structure, the said system comprising in combination:

A magnetic structure having at least one magnetic pole;

A positioning grid for positioning sets of correction dipoles on the said magnetic pole, the said positioning grid being placed and/or designed on the said magnetic pole having a predetermined position and orientation with respect to the said magnetic pole;

A magnetic field measuring arrangement comprising one or more magnetic field sensors which can be positioned at one or more different positions in a space permeated by the magnetic field generated by the said magnet structure, said space being optionally delimited by a virtual closed surface, such as a spere or a spheroid;

A processing unit comprising inputs for the signals acquired by the oner or more magnetic field sensors and for the positions in the said space of the said one or more sensors corresponding univocally to each one of the signals acquired by the said sensors;

Said processing unit comprising a memory in which a program is saved comprising the instructions for calculating the coefficients of a polynomial expansion, preferably of an harmonic expansion describing the magnetic field measured by the said one or more magnetic field sensors as a function of the signals acquired by the said sensors and the univocally associated position in space and which program is loadable and executable by the processor of the said processing unit;

Said processing unit comprising a memory in which a program is saved comprising the instructions for calculating the coefficients of a polynomial expansion, preferably of an harmonic expansion describing a theoretical magnetic field having a predefined target homogeneity and which program is loadable and executable by the processor of the said processing unit;

Said processing unit comprising a memory in which a program is stored comprising the instructions for calculating one or more alternative sets of correction dipoles, each correction dipole having a certain charge a certain sign of the charge and a certain position on the gird, which one or more sets of correction elements is calculated by applying a minimization algorithm of the differences of the coefficients of the polynomial expansion determined as a function of the measured data of the effectively generated magnetic field and the coefficients of the said polynomial expansion determined as a function of the said theoretical field having the said target homogeneity and which program is loadable and executable by the processor of the processing unit;

Said processing unit comprising a memory in which a program is sored comprising the instruction for carrying out the steps of the shimming process according to one or more of the embodiments of the method for shimming magnets disclosed above and which program is loadable and executable by the processor of the said processing unit;

Said processing unit comprising a memory in which a database is loaded, the data of the said database relating to the historical data of shimming processes of magnets executed in the past and which data is structured and coded according to the one or more method steps discloses above and which database can be accessed in retrieving data and/or in storing new data by the said one or more programs which are loadable and/or executable by the processor of the said processing unit;

The system further comprising one or more output interfaces for the calculated sets of correction dipoles at each or at some of the iteration steps of the shimming process or at the final iteration step of the shimming process relatively to the number, the charge, the sign of the charge and the position on the positioning grid of the said correction dipoles, the said output interface being driven by the said processing unit;

The said output interface comprising at least one monitor in which the said data is printed in alphanumeric form and or in graphical form;

The said processing unit further comprising one or more input interfaces connected to an input of the processing unit, for inputting commands and or settings and or selections by an operator.

Further features and embodiments of the above system are disclosed in the following description.

According to an embodiment the magnetic structure is part of a magnetic resonance imaging apparatus.

The system for carrying out the shimming method is preferably a device which is separated and independent from the magnetic structures to be shimmed and thus also from the MRI apparatus comprising the said magnetic structures.

According to an embodiment an automatic pic and place device for the correction elements is provided, such as a robotic arm, which is provided in combination with a magazine of differently magnetically charged correction elements and a control unit of the said robotic arm which controls the pic and place operations of the correction elements on the positioning grid according to the compute distribution and which control unit receives the coordinates of the position of each correction element and the information of which kind of correction element is to be put in place at a certain coordinate on the grid from the processing unit and generates the commands to drive the robotic arm.

Brief Description of the drawings

Figure 1A, 1B and 2 show examples of the state of the art relating to a positioning grid of a distribution of correction elements in a magnet structure of an MRI apparatus.

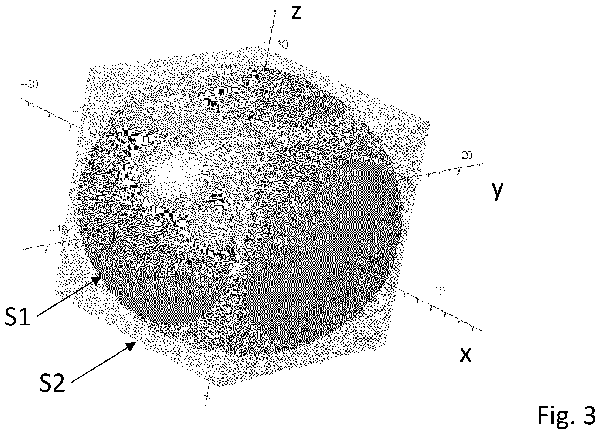

Figure 3 is a schematic example of a spherical virtual boundary of a space permeated by the magnetic field to be measured according to the method of the present invention.

Figure 4 is a high level diagram representing the scheme of an embodiment of the method according to the present invention.

Figure 5 shows a flow diagram of an embodiment of the method according to the present invention.

Figure 6 shows a high level diagram of a system for carrying out the method of the present invention.

Detailed Description of the drawings

As already disclosed in the previous description, the production of Magnetic Resonance Imaging (MRI) systems involves subjecting the permanent magnets of each new device to a shimming procedure, which allows the magnetic field to be uniform within the measurement volume. The measurement volume being e limited region of the volume permeated by the magnetic field generated by the magnet and generally delimited by the said magnet, as for example shown in figure 1B and described in the previous description.

The procedure, which consists in the application of dipoles on the surface of the magnet within a grid of discrete positions (radii and angles), is supported by an algorithm that suggests the quantities of charge to be positioned. The operator inserts the charges as indicated by the algorithm, with the possibility of making changes based on his own experience. See for example the figures 1 A and 2 and the relating disclosure in the preceding description of the state of the art.

The duration of shimming in terms of "steps" to reach the desired tolerance of the homogeneity of the magnetic field has a high variability from magnet to magnet.

In the following detailed description of embodiments of the method according to the present invention, the method is disclosed in relation to a particular embodiment of the magnet in which the magnet has at least one, or two opposed magnetic poles which have/has circular shape and circular symmetries. Without being considered a limitation of the kind of magnets which can be shimmed with the method according to the present invention. This example having circular symmetry helps in simplifying the formalism and the description and putting in the foreground the essential features of the method.

When using an harmonic expansion for describing the magnetic field generated by a magnet having at least one magnetic pole of circular shape it is possible to find eight sections which are called in the following eight symmetry sections:

1. DDC (odd odd cosine)
2. DDS (odd odd sine)
3. DPC (odd even cosine)
4. DPS (odd even sine)
5. PDC (even odd cosine)
6. PDS (even odd sine)
7. PPC (even even cosine)
8. PPS (even even sine)

Sine and Cosine being the basis functions of the harmonic expansion and the indications odd and even referring to the order of the coefficients of the said harmonic expansion.

Harmonic expansions and particularly harmonic spherical expansions are well known mathematical polynomials and a more detailed explanation of the features of the said expansions and the structure of the polynomials is disclosed for example in https://en.wikipedia.org/wiki/Spherical harmonics#Sp herical harmonics expansion which is to be considered part of the present description in view of sufficient disclosure for the skilled person.

The coefficients of such expansions are defined by two order indices generally indicated by the variables 1 and m. these variables can be independently one form the other even or odd numbers and the notation related to the above listed symmetry sections refers to the values 1 and m of the coefficients and to the corresponding basis function, namely cosine and sine of the polynomial expansion. Each combination of 1, m indices identifies a specific coefficient in combination with a basis function.

The aim of the procedure is to reduce, by adding magnetic charges (according to the positions identified in the grid shown for example in fig. 1A), the fluctuations of the magnetic field measurement in each symmetry section, within a certain tolerance of about some ppm relating to the magnetic field in the center of the magnet.

In relation to the above listed symmetries, different tolerances related to the homogeneity of the magnetic field can be defined for each symmetry section or at least for some of the said symmetry sections.

As an example, the said tolerance relating to the difference between the effective magnetic field corrected by shimming and the desired magnetic field are indicated here as:

- Per la simmetria ppc:

  - Coeff(8,0) coseno: < 20ppm in v.a.
  - Coeff(10,0) coseno: < 30ppm in v.a.
  - Coeff(12,0) coseno: < 75ppm in v.a.
  - for all the other coefficients the following tolerance is set: < 10ppm in v.a.

At the moment, the shimming procedure involves iteratively repeating the following activities, some of which require the direct intervention of the operator:

1) The magnetic field is measured at predefined positions on an ideal surface, preferably a spherical or spheroidal surface and optionally also at points in the volume enclosed by the said ideal surface and the expansion, for example according to a spherical or spheroidal harmonic expansion polynomial representing the magnetic field is calculated, i.e. the coefficients of the said expansion are calculated and then divided into the symmetry sections which are present according to the geometry of the magnet, for example the above listed eight symmetry sections for a magnet having a circular magnetic pole and a spherical or spheroidal ideal surface.

2) The Operator chooses a symmetry on which to carry out a first shimming cycle. Following this choice, shimming steps are carried out on the coefficients of chosen symmetry section and each shimming step of the shimming cycle relating to the said symmetry section produces a set of a certain number of correction dipoles having a certain magnetic field strength and a certain polarity (indicated briefly as charge and sign) and a certain position on a positioning grid for the correction elements such as the one shown in figure 1 A.

3) The Operator chooses then the number of dipoles on which to intervene and carries out the following steps:

   a. The number of free positions K is calculated;

b. The Operator defines N number of dipoles that may be sufficient to bring the symmetry into specification, i.e. to correct the magnetic field homogeneity at a target value defined by a tolerance, for example a tolerance having a value as the one disclosed above for the said chosen symmetry section chosen as the first one for carrying out a first shimming cycle.

4) The algorithm for calculating the solutions is executed, in which:

i. N out of K combinations of correction elements are processed to decide the positions of the charges and/or the values of the charges, and/or the polarity;
ii. A total charge limit is defined and all those solutions for which the total charge of the correction dipoles provided for the said solution do not respect the defined total charge limits are excluded;
iii. the remaining solutions are sorted starting from those whose sum of the final (theoretical) coefficients is lower;
iv. Among these solutions, some are equivalent and the operator chooses the solution to use:

- The solution is chosen whose maximum amount of total charge required is lower;
- The Operator observes the positions of the correction dipoles and discards those correction dipoles that may be more complex or that may interfere magnetically with the charges already present on the positioning grid prior to starting the shimming process or determined in a preceding shimming cycle.

5) The dipoles are positioned, starting from the dipoles having a more external radial position on the positioning grid (fig. 1 A) and/or the ones having the higher charge;

a. Here the Operator can choose to insert a different number of dipoles M (usually lower) than the number N indicated by the algorithm and with charges different from those indicated by the algorithm;
b. The type of correction dipole inserted depends on the quantity of charge chosen by the operator;

6) The theoretical effect of the inserted charges of the correction dipoles on the coefficients of the expansion related to the chosen symmetry section is calculated using the principle of superposition of the charges of the chosen symmetry on the magnetic field;
7) The Operator inserts the charges in number, position and quantity defined according to the previous points.
8) The procedure is repeated on the different symmetries until the coefficients of each expansion of the magnetic field fall within the tolerance required by the tolerance specification of each symmetry section and of the global magnetic field such as for example a tolerance of 10ppm compared to the field measured at the center of the magnet.

Essentially, although some differences in the succession of steps may be present or some steps may be omitted, the method according to the present invention follows the above sequence of steps and is directed to provide objective support to the operator in order to carry out one or more or all of the choices or selections indicated in the above disclosed steps of the shimming process. In particular, the support is such that personal skills of the operators are not anymore, a critical aspect of the success and quality of a shimming process and that the personal skills of many different operators having carried out shimming processes on magnets according to the state of the art methods can be offered to disposal of every operator independently from its personal skills.

According to a feature of the shimming method of the present invention the steps are provided consisting in:

a) Generating a database of historical shimming cases relating to a certain specific kind of magnet, by analyzing the data characterizing the steps of the shimming process and of the solutions consisting in the sets of correction dipoles or coefficients of the expansion polynomial and defining a set of independent variables representing each one specific parameters of the said data;
b) generating a model based on the ground truth represented by the said database of historical data of shimming processes or of a selection of the said data;
c) applying the said model in combination with the steps of the shimming process disclosed above for determining the quality of the effects of choosing or selecting an alternative option provided by the said one or more or all of the choices or selections indicated in the above disclosed steps of the shimming process;
d) the operator being addressed to choose the option which is indicated by the model as providing the best effect on the shimming process.

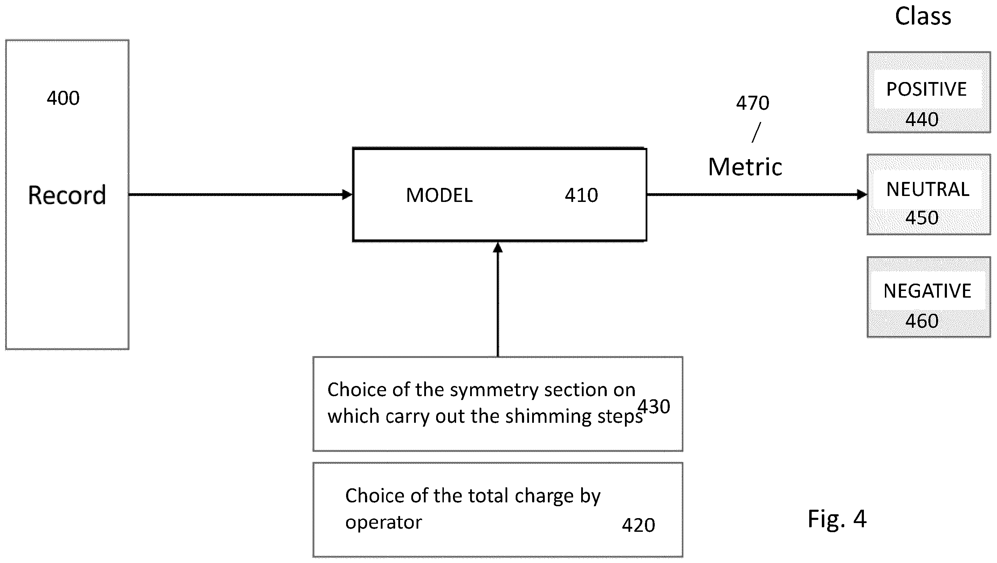

Figure 4 shows a high level diagram of the steps which the pethood according to the present invention introduces in the succession of steps of a shimming process according to the state of the art.
A database 400 of historical data is generated and used to construct a model 410. This model is set such that it is used to determine the quality of a selection or of a choice of the operator relatively to one or more of the different options disclosed above with which the operator is faced in carrying out the shimming process.

Figure 4 shows as a non limiting example relatively to the different kind of choices or selections, the step of selecting by the operator the total charge of a set of correction dipoles indicated by 420 and the step 430 of selecting a symmetry section for carrying out a shimming cycle, this symmetry section being selectable among the symmetry sections provided by the geometry of the magnet as a starting symmetry section or as a symmetry section following the starting symmetry section or among a succession of symmetry sections on which the shimming process is to be carried out.

The model 410 allows to calculate a quality of the one or more selections or choices or of each selection or choice made by the examiner for example according to a classification as positive, neutral and negative as indicated by the boxes 440, 450, 460.

In order to carry out the classification a metric as indicated by 470 in figure 4. In relation to the said metric, the meaning of the term in figure 4 has to be considered encompassing also methods for classifying data which do not operate directly with a metric in a strict sense, but here the term metric comprises, for example, and as it will appear more evident in the following description also machine learning algorithm as classification algorithms or other kinds of classification algoritms.

Common to all the above alternatives for the model 410 itself and for the said metric 470, is the definition of the data of the database 400 which forms the ground truth for the construction of a model 410.

In the following an example of a database for constructing the model is disclosed which relates to 541 identical magnets which has been shimmed using a shimming method according to the state of the art and from which the historical data is determined forming the records of the said database.

First data extracted by analyzing the shimming processes and their outcomes carried out on the 541 magnets are the so-called file records. In this example, without any limiting intention, each file record comprises eight variables which describes an i-th step of the shimming process. These variables may be defined for example as:

| • data['record'][1] | coeffPost | Array of the expansion coefficients of the symmetry section at the following step |
|---|---|---|
| • data['record'][2] | effTeo | Value of the theoretical effect of positioning the correction dipoles with the determined charges, polarities and positions on the positioning grid |
| • data['record'][3] | effShimm | > effective experimental variation of the coefficients of the expansion due to applying the set of correction dipoles |
| • data['record'][4] | misPre | preceding shimming step |
| • data['record'][5] | misPost | following shimming step |
| • data['record'][6] | corShim | Matrix comprising the positioned correction dipoles having the calculated charges, polarities and positions on the grid |
| • data['record'][7] | simmetria | Symmetry section on which the shimming process is currently carried out |

The value of the varibsale coeffPost is calculated by the model 410 coeffPost=coeffPre+effTeo, while the variable coeffPost can be determined experimentally by the equation coeffPost=coeffPre+effshimm

According to a further feature, the database may contain further data which is related to so called expansion files. Each expansion file contains the coefficients of the complete expansion of the magnet at a certain step of the shimming process.

According to a preferred embodiment said coefficients a the coefficients of a corresponding Fourier series and are labeled by the pair of indices l,m in combination with the two basis functions cosine and sine. Thus the data in tabular form may comnprise four columns and a line for each coefficient, which columns relate respectively to one of the indices 1 and m and respectively to one of the basis functions cosine and sine.

From each expansion it is possible to extract the coefficients relating to each symmetry and corresponding to the arrays of coefficients of the Record files, carrying out filtering operations according to the following:

1. The indices 1 corresponding to the first term (for example, odd)
2. The indices m corresponding to the second term (for example, odd)
3. Extracting the column based on the chosen sinusoid (for example, cosine)
4. In the case of PPC symmetry, we start from the indices 1 = 2 and m = 0.

According to still a further feature of the database which can be provided in combination with one or both of the previously described features relating to record and expansion files, the said data of the database of historical data comprises further so called report files.

Considering the solution proposed by the algorithm, according to the methods of the state of the art in carrying out the shimming process the report files comprises the choices made by the operator relating to the number of dipoles to insert on the positioning grid, and which were based on:

the charges of the correction dipoles already inserted (geometric constraints); and
and following its experience the operator could have changed the charge value of one or more correction dipoles to be positioned on the positioning grid or position a smaller number of correction dipoles on the said grid.

A further step of generating the database of the historical data and which can be carried out in combination with anu one of the one or more previously disclosed features of the said database my comprise the step of combining two or more of the described records, expansions and reports files according to one or more or all the following criteria:

1. Elimination of possible duplicate record files;
2. Merging record files with the respective expansion files;
3. Deletion of records without related expansion file;
4. Extraction of further symmetry sections from the expansion files.

Starting from the above database it is possible to construct a model for classifying the data according to more different alternatives.

According to a first alternative embodiment, the data of the above described database are used to construct e parametric metric which allows to measure some sort of distance of a choice of the operator from the solutions described by the data of the said database. In a said first embodiment the data is used for classifying the quality of data records according to the above definition in order to allow the operator to have an indication if the choice between two options related to the positioning of a correction dipole having a certain charge will have a positive or a negative effect on the homogeneity of the resulting magnetic field of the magnet to which the said correction dipole has been added.

A target for the homogeneity may be set according to the symmetry chosen and for example the said target is expressed as the homogeneity deviation tolerances indicated above with:

coeff(8,0) cosine [ppc]: < 20 ppm in v.a.
coeff(10,0) cosine [ppc]: < 30 ppm in v.a.
coeff(12,0) cosine [ppc]: < 75 ppm in v.a.
All the other coefficients: < 10 ppm in v.a.

The said first alternative metric for carrying out classification of the data related to the record files as defined above uses bot the coefficients of the polynomial expansion relating to the symmetry section and to the entire polynomial expansion of a preceding step and of a following step of the shimming process.

According to this first alternative embodiment of a metric, considering the target of tolerance of the coefficients at the preceding step (i-th step) and at the following step (ith+1) step at each step of the shimming process the following is calculated:

1. For the symmetry coefficients:

a) The average value of the coefficients above target;
b) The percentage of coefficients below target;

2. For the expansion coefficients:

a) The average value of the coefficients above target;
b) The percentage of coefficients below target;

3. The values indicated in point 1.a, 1.b, 2.a, 2.b thus obtained are compared between those of the i-th step and those of the (i+1)-th step of each process, and it is considered that:

1. There is an improvement if the values defined in points 1.a and 2.a decrease and/or the values defined in points 1.b and 2.b increase;
2. There is a worsening if the values defined in points 1.a and 2.a increase and/or the values defined in points 1.b and 2.b decrease;

4. The combination of improvement/worsening of the said four identified values leads to the creation of 16 different possible scenarios for each step, which are reduced into 7 stratification classes:
very_good, good, good_coeff, doubt, neutral, bad, very_bad

A step is considered to belong to a positive class when at least two of the aforementioned values are improved, otherwise they are classified as neutral or negative steps.

According to a second alternative metric for classifying the data defined above for the record files, the said metric uses the coefficients of the polynomial expansion related to a symmetry section and of a previous and following step of the shimming process.

Considering the target of the tolerance of the coefficients at the preceding step (i-th step) and at the following step (ith+1) step at each step of the shimming process the percentage variations for each coefficient are calculated, to which weights are applied for taking into account the following:

1. The kind of variation of the coefficient: Specification weights:

Case 1: the coefficient remains above specification (neutral);
Case 2: the coefficient before is above and after is below the specification (improvement);
Case 3: the coefficient before is below and after is above the specification (worsening);
Case 4: the coefficient remains below specification (neutral);

2. Position coefficient: Position weights Coefficients of larger orders will have less weight.

Records are divided into three classes based on the metric value into positive, neutral, negative based on two threshold values. The so-called bin thresholds for selecting the classes were selected to allow optimal classification through standard algorithms (in terms of repeatability).

In this alternative embodiment the classification model needs to determine the values of many weights. Furthermore, the division in classes of the data is not surely independent from the dataset. Another limitation of this second alternative embodiment of a metric is the fact that the metric considers only the coefficients of a symmetry section and not all the coefficients of the entire polynomial expansion.

According to a further alternative embodiment a metric is provided improving the second alternative embodiment disclosed above and is described by the following formula:

$$\sum_i Weight\_pos_i \frac{\frac{sign(Cpre_i, Cpost_i)*(Cpost_i - Cpre_i)|Cpost_i - Cpre_i|}{Cpre_i} * Specific\ weights_i}{\left(\sum Weight\_pos_i\right)}$$

In which

I:= index of the processing step of the shimming process;
C post$_i$: the coefficients of the records determined in a following step i;
C pre$_i$: the coefficients of the records determined in a preceding step i;
Specificweights$_i$: there are 4 coefficients [A, B, C, D] depending on the following conditions at a step i:

Condition A: the coefficient remains above the specification and the quality or the effect of the step is classified as neutral;
Condition B: the coefficient before is above and after is below the specification and the quality or the effect of the step is classified as improvement;
Condition C: the coefficient before is below and after is above the specification and the quality or the effect of the step is classified as worsening;
Condition D: the coefficient remains below specification and the quality or the effect of the step is classified as neutral;

**Weight-pos$_i$:** Weights that indicate the position of the coefficients at step i:

Constants, equal to 1;
Linearly decreasing;

Sign: Function to take into account the sign variations in the coefficients.

According to a feature related to the use of the above metric, the said metric is applied for classification only in relation to two quality classes labeled as positive and negative.

In relation to classification of the coefficients relative to a certain step I of the shimming process withing a certain symmetry section, many different classification methods can be used applying different classification algorithms among which also classifiers based on machine learning algorithms. In the following list non-limitative examples of classifiers are disclosed which can be used for carrying out the classification task in relation to the quality classes determined basing on the database of the historical data and using one of the above disclosed models and/or metrics: Random Forest Classifier, XGB Classifier, Classifier based on Cross Validation algorithms, Binary classification algorithms and other algorithms known at the state of the art for working as classifiers.

The above disclosed embodiments of the metrics are all related to classify the quality of choices related to the data which has been defined in the previous description as record files and withing a certain symmetry section of the symmetry sections provided by the geometry of the magnet to be shimmed and/o the magnetic field generated by it.

The shimming method according to the present invention can also comprise steps related to the support of the operator in choosing a starting symmetry for carrying out the shimming process and a sequence of one or more of the remaining symmetry sections provided by the geometry of the magnet and/or of the magnetic field on which carry out in succession further shimming cycles.

According to a further embodiment of the present invention this step relating to the choice of the starting symmetry section and of the sequence of one or more of the remaining symmetry sections comprises the following steps:

Providing a database of historical data relating to the shimming processes carried out on identical magnets and related to the effects on the quality of the shimming process caused by a choice of a symmetry section;
Clustering the record, preferably in a non supervised manner and preferably on only two clusters;
Selecting a cluster;
Using a metric according to one of the alternative embodiments disclosed above for the said metric in order to classify the symmetry section choices basing on the historical data; Computing the percentages of records labeled as positive, neutral and negative;
Defining as the suggested or preferred choice of a symmetry section on which a shimming cycle of the shimming process has to be carried out the one for which the relating data defined above as records has been classified as being positive;
Carrying out the shimming process for the said suggested symmetry section and in succession for each of the one or more remaining symmetry sections suggested.

The database of historical data can be the same one as disclosed in relation to the construction of the model for classifying the choices to be taken at each shimming step within a certain symmetry section.

According to one embodiment, the clustering of the historical data is carried out by applying statistical clustering methods and algorithms, as for example a so-called K-means clustering algorithm. K-means is based on so-called centroids. The centroid is a point belonging to the space of features that averages the distances between all the data belonging to the cluster associated with it.

According to a further embodiment, the clustering may be carried out by a statistical clustering method providing the following steps:

Extraction of symmetry sections from the complete polynomial expansion;
Calculation of the averages of the coefficients of the said symmetry sections;
Calculation of the medians of the mean vectors for each symmetry section;
Statistical division into 256 clusters based on the comparison of the 8 averages of the symmetry sections with respect to the medians calculated in the previous step, while the suggested or best starting symmetry section and or the succession of symmetry sections on which the shimming process has to be consecutively carried out is determined by
Selecting a cluster;
Using a metric, for example a metric of the one or more previously described alternative embodiments for classifying the quality of the possible choices of the starting symmetry section and of the said succession of one or more symmetry sections on which the shimming process has to be consecutively carried out;
Determining the percentage of the positive, negative and neutral record and individuating the best or the suggested starting symmetry section or said succession of symmetry sections based on the comparison of the said percentages.

The method according to the above disclosed embodiment and using a statistical model is capable of self-updating with each new registration in the database of a new shimming step. In this way the «experience» acquired by the operators is continuously considered.

The indications of the model are intended to reduce to a minimum, to the point of eliminating, all the shimming steps that are labeled as bad for the process. The same model could be applicable considering insertion of charges on the magnets.

According to the above finding an alternative embodiment of the present shimming method comprising a step for supporting the choices of the operator in selecting the correction dipoles can be applied which statistical model comprises the steps of:

Creation of a dataset comprising data of each single correction dipole relating to its charge, polarity and position and being considered as an element which is independent of the other correction dipoles even in cases in which at each step two or more correction dipoles are to be positioned on the positioning grid.

Similarly as for the clustering related to the choice of the starting symmetry section and/or for a succession of one or more symmetry sections, also in this case many different clustering techniques may be applied.

In one embodiment the clustering is carried out by applying a so-called k-means clustering algorithm.

By selecting a cluster, then carrying out classification of the of the symmetry section choices of the historical data using one of the above embodiments for a metric and calculating the percentage of the positive, negative and neutral records the statistical model disclosed above provides for suggesting the best symmetry section or the best succession of one or more symmetry sections and also the best set or sets of correction dipoles on which carrying out the shimming process at each step of positioning a certain correction dipole and/or a group of correction dipoles.

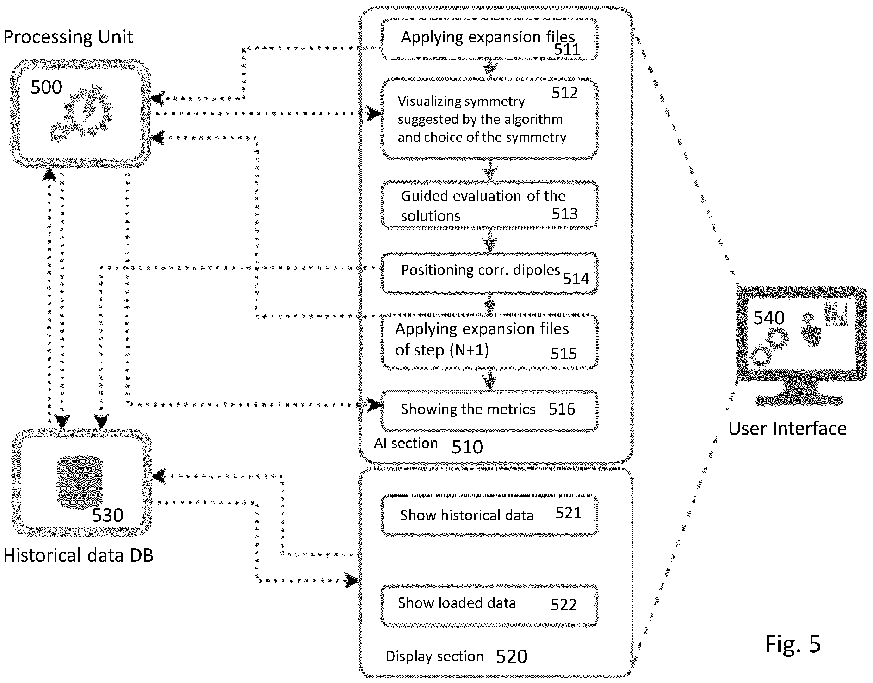

Figure 5 shows a diagram of a system for carrying out the shimming method according to any of the disclosed embodiments. With 500 a processing unit is indicated which by loading and executing a program in which the instructions are loaded for carrying out the algorithms od the shimming process becomes able to carry out the steps of the shimming process according to any of the variant embodiments of the present invention disclosed above. The processing unit 500 accesses in writing and reading a memory comprising at least an AI section in which the program is stored for carrying out the steps of the method according to one or more of the above disclosed variants and as an example the steps 511 of applying or loading in the algorithm the data related to the above defined expansion files of the steps i of the shimming process; next, at step 512 visualizing the symmetry sections which are available for the geometry of the magnet to be shimmed and suggesting a symmetry section or a succession of one or more further symmetry sections of the available symmetry section among which the operator may choose or not a starting symmetry section and/or a succession of the said further one or more symmetry sections; As indicated by 513, the program comprises the instructions for carrying out said step 513 consisting in further guiding the evaluations of the one or more solutions generated as consequence of the symmetry choice at the further step 512. The program stored in the AI section comprises also the instructions for carrying out a step 514 for positioning one or more correction dipoles on a positioning grid provided in the magnet to be shimmed either virtually or in the reality. The program comprises the instructions for carrying oit step 5151 of applying the data of the expansion files calculated at step N+1, while as indicated by 516 the program comprises a section with the instructions to show the metrics to the user.

According to a further feature, a section of the memory indicated by 520 is provided in which a program is loaded for carrying out the steps of showing historical data 521 from a database 530 of historical data related to shimming processes carried out on identical magnets. Also the loaded data can be shown as indicated by the instructions 522 in figure 5. The loaded data and the computed data can be displayed on a user interface 540 comprising one or more monitors and/or other display means. The user interface 540 may also comprise any kind of device for inputting data and/or commands to the processing unit 500.

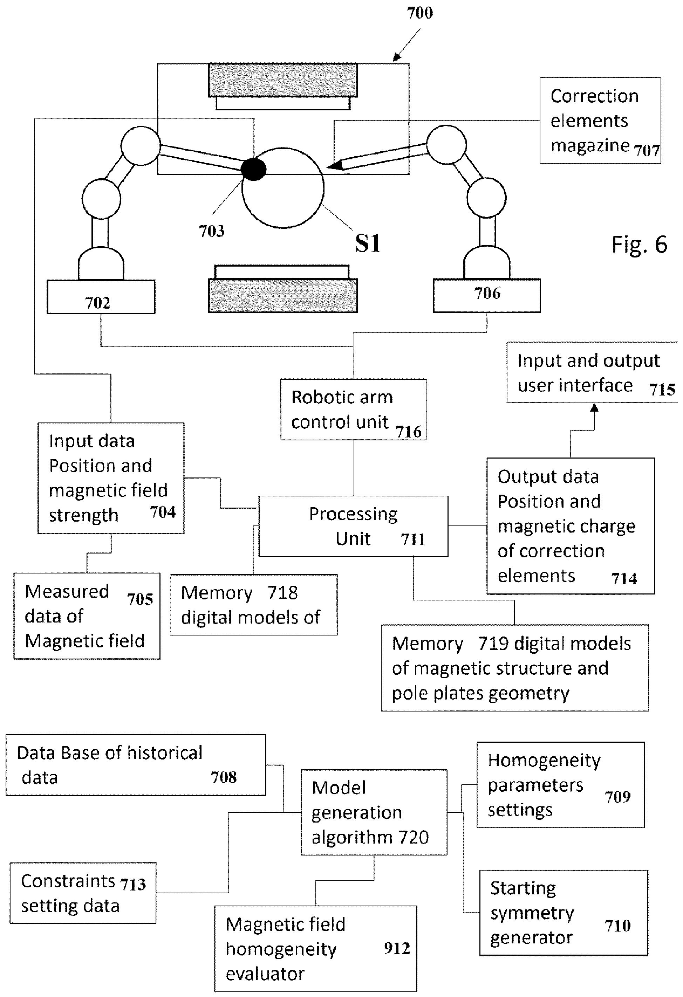

Figure 6 is a block diagram of a system for determining the distribution of correction elements of the magnetic field executing one or more algorithm provided by the one or more embodiments disclosed in relation of the method for correcting inhomogeneity of the static magnetic field, particularly of the static magnetic field generated by the magnetic structure of a machine for acquiring nuclear magnetic resonance images and MRI system for carrying out such method.

In the embodiment of figure 6 the system for automatically determining by means of a machine learning algorithm, as disclosed above in the different embodiments, is configured also for automatically executing the pick and place of the correction elements determined according to the distribution computed by the algorithm and also for automatically measuring at predetermined space position the strength of the magnetic field generated by the MRI magnet in a volume. These organs for carrying out the pick and place and the measuring at predeterminate points of the magnetic field may be realized in many different ways.

Numeral 700 indicates a magnet and 701 a volume permeated by the magnetic field generated by the magnet. An automatic magnetic field measuring unit consisting in a robotic arm 702 carrying o its end effector a probe 703 is shown and the measured data is fed to an input interface 704 for the position of the measurement point and the magnetic field strength measured at the said points. The database comprising these data is stored in a memory 705.

A further robotic arm may be provided indicated by 706 which carry at it end effector a grasping device for picking up one correction element from a correction elements magazine 707 and place the said correction elements at the position on a positioning grid, for example according to one of the embodiments of figures 1 or 2, which has been determined by the computed distribution of correction elements.

A memory 708is provided in which the Database of known cases or of the historical data according to the one or more variant embodiments of these data is stored.

A model generation algorithm 720 provides for the generation of a model from the data of the said Database 708, which data is stored for being retrieved by the processing unit 711 for generating a model by analyzing and clustering the said historical data in groups of data relating to a certain quality of the process steps executed relatively to target homogeneity settings 709 on the records of the database 708.

The processor 711 controls each one of the peripherals shown in figure 6 and carries out the process for determining the distribution of correction elements to best shim the magnet. The one or more models and the one or model possible classification algorithms being executable alternatively or in combination according to different machine learning models, are stored in a memory 712 and the different algorithms may be recalled from a machine learning algorithm model library 713. An output 714 provides the results of the processing as a distribution of correction elements each one having a specific position on a positioning grid and a specific magnetic charge among the ones available in the magazine. A display 715 may be provided for displaying in the form of alphanumeric data the distribution of correction elements by indicating position coordinates of the same ones and the corresponding magnetic charge and/or by showing an image of the positioning grid with the correction elements according to the computed distribution positioned on it.

The processor unit 711 controls a robotic arm control unit 716 which drives the robotic arms for carrying out their tasks. Particularly for picking the correct correction elements from the magazine and placing each one at the computed position of the positioning grid.

The above disclosed system may be a combination of dedicated hardware and software or it may be in the form of a PC or a workstation in which a software is loaded comprising the instructions to enable the conventional PC or workstation and their peripherals to carry out the functions of the unit disclosed in figure 6.

## Claims

1. Method for correcting inhomogeneity of the static magnetic field generated by a magnetic structure, particularly of the static magnetic field generated by the magnetic structure of an MRI system comprising the following steps:

   i) defining a criterion for evaluating the homogeneity of a magnetic field by at least one parameter describing the said homogeneity of a magnetic field generated by a magnet structure having a predefined shape and/or a predefined distribution of magnetic field generating units and setting at least one threshold value of the said at least one parameter describing a target homogeneity of the said magnetic field;

   ii) selecting an harmonic, spherical or spheroidal expansion representing the magnetic field generated by a magnet to be shimmed and comprising a plurality of harmonic terms, each associated to a coefficient;

   iii) defining a grid for positioning correction elements on said magnet structure, depending on the shape of the magnet structure and/or of the magnetic field generated by said magnet structure;

   iv) carrying out a shimming process comprising the steps of:

   v) measuring the magnetic field and sampling it at a plurality of locations, which are defined according to predetermined spatial distribution pattern;

   vi) determining the coefficients of the said harmonic spherical or spheroidal expansion function representing the magnetic field from the said measured sample values of the magnetic field;

   vii) determining at least one or more sets of correction elements comprising one or more magnetic field correction dipoles each one producing a magnetic dipole field of a determined strength and thus having a determined charge and a determined sign or polarity, and each of the said correction elements being associated to a calculated position on the said grid, by carrying out a minimization algorithm of the differences between the coefficients of the said harmonic expansion calculated from the measured values of the magnetic field at step iv) and of the coefficients of the said harmonic expansion calculated for the target magnetic field having said target homogeneity condition,

   the said minimization algorithm providing at least two different and alternative sets of correction dipoles relatively to the charge and/or the sign and/or the position on the positioning grid of the corresponding correction dipoles and which at least two different sets of correction dipoles generates a corrected magnetic field at least approaching the target homogeneity condition;

   viii) selecting one set of correction dipoles of the at least two different sets of correction dipoles calculated according to step vi) ;

   ix) at least theoretically evaluating the effects of the said set of correction dipoles on the homogeneity of a corrected magnetic field which is the magnetic field generated by the magnetic structure and the said set of correction dipoles having each a calculated charge, a calculated polarity and a calculated position on the said grid, by determining if the value of the homogeneity of the said corrected magnetic field is at least approaching or getting away from the said target homogeneity condition defined at step i);

x) repeating, if necessary, the sampling operation and the steps iv) to viii) and adding for each iteration the respectively calculated correction dipoles to the ones calculated for previous iteration steps till a corrected magnetic field is generated for which said target homogeneity condition is achieved within predefined tolerances;

xi) the choice at step viii) of selecting a set of correction dipoles calculated according to step vii) among the said one or at least two sets of correction dipoles is carried out by providing a classification model for evaluating the quality of the selected set of correction dipoles in generating a corrected magnetic field which is at least approaching the target homogeneity;

said classification model being used to classify according to at least two quality classes the sets of correction dipoles calculated at each iteration of the said processing steps of said shimming process or to predict the quality class to which the said sets of correction dipoles belong among at least two predefined quality classes, the said at least two quality classes are discriminated by

the effect on the homogeneity of the magnetic field generated by the magnet to be shimmed in combination with the said set of correction dipoles placed on the grid and which correction dipoles have a calculated charge, a calculated polarity and a calculated position on the positioning grid;

the said effect relating to approaching to said target homogeneity condition or in getting away from the said target homogeneity condition evaluated by the said homogeneity criterion defined at step i), and the said at least two quality classes being determined by classifying on at least two quality clusters the set of correction elements calculated at an iteration step of the shimming process,

one of the said clusters representing a quality class of sets of correction elements determined in each iteration step of shimming processes carried out for identical or equivalent magnetic structures and memorized in a ground truth knowledge database,

the said at least two clusters collecting respectively in a first one of the said at least two clusters, data of a processing step, which has generated a set of correction elements which at least do not cause a getting away of the corresponding corrected magnetic field from said target homogeneity condition or have caused an approaching to the said target homogeneity condition and, in a second of the said two clusters, a set correction elements which has caused a getting away of the corrected magnetic field from the said target homogeneity condition.

2. Method according to claim 1, in which the quality of the sets of correction elements in relation to an approaching to the said target homogeneity condition and in relation to the getting away of the said target homogeneity condition are expressed as a function of the coefficients of the said spherical or spheroidal harmonic expansion describing the magnetic field of said correction elements and/or of the total magnetic field of the magnet combined with the said correction elements.

3. Method according to claim 1 or 2, in which the physical positioning of the correction dipoles determined for a set of correction dipoles at each iteration of the steps of the shimming process is carried out at least for one or more of the iterations of the said steps of the shimming process, the effects of the said set of correction dipoles calculated at each of the said one or more iteration steps on the effectively measured magnetic field of the magnet or of the effectively measured corrected magnetic field for one or more preceding iteration of the shimming process, may be theoretically calculated instead of carrying out a physical placing on the positioning grid of the correction elements, by calculating said effect for each of the said one or more iteration steps in a theoretical or virtual manner, and when a theoretically calculated homogeneity is achieved by a corrected magnetic field which satisfies the said target homogeneity condition within predefined tolerances, then the process of effectively placing the said sets of correction dipoles on the positioning grid for all correction dipoles calculated at the said one or more iteration steps or calculated as the final set of correction elements is carried out and the homogeneity of the corrected magnetic field is effectively measured and compared with the target homogeneity condition in order to determine if the target homogeneity condition has been effectively achieved within the predefined tolerances.

4. Method according to one or more of the preceding claims in which the step is carried out of identifying one or more symmetry sections present in a kind of magnetic structure and in the coefficients of the harmonic expansion describing analytically the magnetic field generated by said magnetic structure and the shimming process is carried out in succession starting from a selected symmetry section among the several symmetry sections identified and by carrying out the shimming process for all of the said symmetry sections identified or for at least some thereof according to a certain sequence of the said symmetry sections.

5. Method according to claim 4 in which prior to carrying out the step vii) the additional step is carried out of choosing one of the said symmetry sections as a starting symmetry section on which carrying out the iterative steps of the a first cycle of said shimming process by considering the coefficients of the said harmonic expansion function belonging to the said chosen starting symmetry section, the steps of the said first cycle of the shimming process being iteratively repeated till the said target homogeneity condition has been achieved within the said symmetry section, while after having terminated the shimming process on said first symmetry section, the iterations of the steps of the shimming process are carried out in sequence on each of the further symmetry sections identified by considering the coefficients of the harmonic expansion belonging to each of the said further symmetry sections and the said target homogeneity condition,

optionally for some or all of the said symmetry sections different target homogeneity conditions being defined and/or also tolerances in determining if the said homogeneity target conditions have been achieved.

6. Method according to one or more of the preceding claims in which in combination with a starting symmetry section selecting step and with a definition of the sequence of the one or more of the further symmetry sections the following further steps may be provided:

providing a classification model of the selectable symmetry sections as starting symmetry section according to the effectiveness in approaching to said target homogeneity condition or in getting away from the said target homogeneity condition and in defining a sequence of the remaining one or more symmetry sections on which carrying out the iteration steps of the shimming process;

classifying the symmetry sections individuated for the magnet structure which must be shimmed according to the said classification model and using the starting symmetry section and the sequence of the remaining one or more symmetry sections for carrying out the iteration steps of the corresponding cycles of shimming process indicated by the said classification,

the said classification model being generated by classifying and/or clustering relatively to their effectiveness in approaching to or getting away from a target homogeneity condition provided for the said symmetry sections, the data related to the selection of starting symmetry sections and of the sequences of the one or more remaining symmetry sections taken by the human operator according to historical data related to the shimming processes carried out in the past on similar or preferably identical magnets and saved in a database of symmetry selection records.

7. Method according to one or more of the preceding claims in which one or more further steps selected from the following list may be carried out:

before carrying out the steps of the shimming process and/or of a starting symmetry selection and optionally of the said sequence of symmetries setting the total number of correction dipoles which has to be used for carrying out the shimming process is defined;

the number of free positions is determined which positions are available on the gird for positioning the correction dipoles, resulting from one or more of the iterations of the shimming process carried out for one or more or all the symmetries available form the harmonic expansion and for each iteration step of the shimming process;

defining a limit of the magnetic charge for each or at least each of some of the correction dipoles and/or defining a limit of the total charge of the correction dipoles calculated by an iteration step of the shimming process, and

excluding each combination of correction dipoles determined in carrying out each iteration step of the shimming process and/or for each selected symmetry section overcoming the said limits and

choosing the said combination of the said correction dipoles for which the said total charge is the lowest.

8. Method according to one or more of the preceding claims in which the additional step is provided of allowing the operator to observe the positions calculated for each combination of correction dipoles on the grid and to discard those combinations of correction dipoles for which the corresponding positions on the grid may be more complex than for other combinations of correction dipoles or for which combination the position of at least one or more of the correction dipoles may interfere physically or magnetically with the position and/or the magnetic field of correction dipoles already present on the said positioning grid.

9. Method according to claim 8, in which said additional step, comprises generating a virtual image of the positioning grid and of the correction dipoles and displaying on a monitor the said virtual image by showing the position of correction elements already placed on the grid by executing preceding iteration steps of the shimming process and also showing the positions of each of the correction elements determined in the current iteration step of the shimming process; and

optionally the correction elements being differentiated one from the other relating to their physical dimensions and/or to the charge and/or to the polarity, by using differentiating graphic features;

and optionally the human operator being allowed to select one or more images of the correction elements and displace them onto different positions of the grid and/or change the strength or polarity of the magnetic field and/or discard one or more correction elements from the image of the positioning grid,

while a feedback of one or more of these actions modifying the number and/or position and/or the charge and/or the polarity and/or the position of the said one or more correction dipoles is provided by calculating the effects on the coefficients of the expansion and/or on the classification relating to the quality of the effects on the homogeneity.

10. Method according to one or more of the preceding claims in which the classification model can be generated according to one of the alternatives disclosed in the following list or to a combination of two or more of the said alternatives:

a machine learning algorithm or a combination of machine learning algorithms which is/are configured to work as a classification algorithm, said machine learning algorithm or said combination of machine learning algorithms being trained by a ground truth database comprising records in which parameters are saved describing the shimming process of historical cases relating to the shimming of identical or equivalent magnetic structures,

the said parameters coding the data of the iteration steps of the shimming process such as the number, the charge, the sign of the charge and the position of correction dipoles calculated at each iteration step of the shimming process, the total charge of the correction dipoles and/or the corresponding coefficients minimizing the differences between the effectively generated magnetic field and the theoretically expected target magnetic field in relation to the target homogeneity, and/or the symmetry for which the said correction dipoles and the said coefficients are calculated,

while the output data consisting in clusters in which the data of an iteration step of the shimming process coded by the said parameters are grouped according to the effectiveness in achieving or at least approaching more or less the target homogeneity by the corrected magnetic field;

a so called statistical parametric model, which comprises a parametric metric function considering predetermined parameters describing features of data available form an historical database for generating clusters of data showing the same or similar features,

said features are the quality features of the set of correction dipoles and/or of the coefficients of the harmonic expansion calculated at each iteration of step of the shimming process by carrying out the minimization algorithm in relation to the effectiveness in approaching and/or in getting away from the target homogeneity condition and/or the features of effectiveness in approaching to or getting away from a predetermined target homogeneity condition of the selection of the starting symmetry sections and/or of the sequence of the remaining symmetry sections for which carrying out the steps of the shimming process;

said parametric function being used for evaluating the said quality and effectiveness features of the selection of a calculated combination of correction dipoles for each iteration step and/or for each selection of the starting symmetry section and of the said sequence of the one or more remaining symmetry sections which evaluation is an objective guide for the operator to make a certain selection.

11. Method according to claim 10, in which said classification model include a clustering algorithm such as for example a k-means clustering algorithm.

12. Method according to one or more of the preceding claims in which further one or more of the further steps of the following list is carried out:

Eliminating of duplicated or n-tuplicated records;
Combining the coded data relating to the label records with the corresponding coded data labeled expansion;
Eliminating every record comprising coded data for which no expansion data is available;
Extracting the data coding the further symmetries from the expansion data.

13. Method according to claim 10 or 12, in which the following values for each iteration step of the shimming process relating to a prevoius (i-th) iteration step and to a following ((i+1)-th) iteration step are calculated:

1. For the coefficients related to a symmetry:

a) The average value of the coefficients which generates a magnetic field having a homogeneity condition above the target condition;
b) The percentage of coefficients which generates a magnetic field having a homogeneity condition below the target condition;

2. For the expansion coefficients

a) The average value of the coefficients which generates a magnetic field having a homogeneity condition above the target condition;
b) The percentage of coefficients which generates a magnetic field having a homogeneity condition below the target condition;

3. The above values are determined for the an i-th iteration step and an i-1th iteration step and are compared, whereas:

- It is considered that there is an improvement of the homogeneity condition toward the target homogeneity condition if the above determined values determined at steps 1a.) and 2a.) decrease and/or the values determined at steps 1b.) and 2b.) increase;
- It is considered that there is a worsening of the homogeneity condition relatively to the target homogeneity condition if the values determined at steps 1a.) and 2a.) increase and/or the values determined at steps 1b.) and 2b.) decrease.

**14.** Method according to claim 10 or 12, in which said parametric metric is a function of the coefficients of a symmetry section selected for carrying out an iteration step and which coefficients are the one of a previous (i-th) iteration step and of a following (i+1-th) iteration step, while considering the target homogeneity condition and tolerance, the percentage changes of each coefficient of the said symmetry are calculated for each iteration step of the shimming process relating on the coefficients of a previous (i-th) iteration step and on the coefficients of a following ((i+1)-th) iteration step and to the said coefficients weights are applied which takes into account the way of the said changes defined by the following four cases:

• Case 1: the coefficient remains above specification (neutral)
• Case 2: the coefficient before is above and after is below the specification (improvement)
• Case 3: the coefficient before is below and after is above the specification (worsening)
• Case 4: the coefficient remains below specification (neutral).

**15.** Method according to claim 13 or 14, in which said parametric metric is described the following formula, in which the index i relates to the ith iteration step:

$$\sum_i Weight\_pos_i \frac{\frac{sign(Cpre_i, C\,post_i) * (Cpost_i - Cpre_i)|Cpost_i - Cpre_i|}{Cpre_i} * Specific\,weights_i}{(\sum Weight\_pos_i)}$$

$Cpost_i$ are the coefficients after the i-th iteration step has been carried out;
$Cpre_i$ are the coefficients before the i-th iteration step has been carried out;
The term Specificweights relates to four parameters defined in the following as [A, B, C, D] which indicates the relation of the coefficients $Cpre_i$ and $Cpos_i$ relatively to a target value of the said coefficients and in which:

Parameter A indicates that the value of the coefficient remains above the target value corresponding to a quality of the iteration step labeled as neutral;
Parameter B indicates that the that the value of a coefficient $Cpre_i$ is above the target value and the value of the same coefficient at the following iteration step $Cpos_i$ is below the said target value corresponding to a quality of the iteration step labeled as better;
Parameter C indicates that the that the value of a coefficient Cprei is below the target value and the value of the same coefficient at the following iteration step Cposi is above the said target value corresponding to a quality of the iteration step labeled as worse;
Parameter D indicates that the value of the coefficient remains below the target value corresponding to a quality of the iteration step labeled as neutral;

Weight_pos$_i$ are weights of the coefficients at the i-th iteration step which indicates the position of the coefficient in the expansion and which weights are set as:

Value 1 if the coefficients are constant or are descending with the position according to a linear function.

Sign is a function considering the variation of the sign of the values of the coefficients.

**16.** Method according to one or more of the preceding claims comprising the following steps:

clustering the historical data relating to the symmetry selections of starting symmetry and sequence of further symmetries of shimming processes carried out in the past on at least similar or identical magnetic structures as the one to be subjected to a shimming process, said clustering being carried out by means of a statistic clustering method comprising the following steps:

determining from a complete expansion function describing the magnetic field related to one or more historical data of shimming processes carried out in the past the existing symmetry sections;

calculating the mean values of the coefficients of the expansion for each of the said symmetries;

calculating the median of the vectors of the means for each symmetry;

statistical division of the parametric data relating to the data of the historical shimming processes labeled as records and according to the above disclosed definition on a predetermined number of cluster basing on the comparison of the means of the symmetries in relation to the median calculated at the preceding step;

generating a statistical model for determining the selection of a starting symmetry among the possible symmetries provided for the magnetic field of the magnetic structure to be shimmed and its expansion and for determining the sequence of the further symmetries on which the shimming process has to be separately carried out,

the said statistical model being applied by carrying out the steps of

selecting a cluster of the data labeled as records according to the above definition, preferably a cluster comprising a higher number of said records in comparison to the other clusters,;

applying one of the metric defined above, preferably the metric defined by the formula

$$\sum_i Weight\_pos_i \frac{\frac{sign(Cpre_i, C\,post_i) * (Cpost_i - Cpre_i)|Cpost_i - Cpre_i|}{Cpre_i} * Specific\,weights_i}{(\sum Weight\_pos_i)}$$

For classifying the quality according to the above defined parameters describing the specific_Weighs defined above;

Calculating the percentage of the records labeled whose coefficients are labeled as better, neutral or worse and

Defining as the suggested or most promising starting symmetry the symmetry for which the percentage of coefficients having the quality better according to the above metric is higher and/or

Defining the order of the symmetries of the sequence of the further symmetries on which to carry out the shimming process by selecting the symmetries having progressively lower percentage of records having the quality defined as "better" according to the above metric.

**17.** Method according to claim 16, in which the said method comprises in combination a statistical model for classifying the shimming results in relation to the strength of the magnetic dipole field of each correction dipole and of the position on the grid of the said correction dipoles according to a selection of the strength of the magnetic dipole fields (magnetic charges) attributed to each correction element and to the corresponding position on the positioning grid which is based on the quality of the said selection relatively to the approaching to the target homogeneity, neither approaching nor getting away from the said target homogeneity and getting away from the said target homogeneity and wherein the following steps are provided:

- clustering each of the correction elements relating to the data of the historical shimming processes and in each of the iterations of the shimming process in a predefined number of clusters;

- dividing the different charges of the correction dipoles in each of the said clusters relatively to groups of correction dipoles having different qualities of determining an approaching to the above defined homogeneity target, providing no variation in relation to approaching or getting away from the target homogeneity, and getting away from the target homogeneity;

- applying the statistical parametric metric according to the above formula for selection the starting symmetry and the sequence of further symmetries;

- calculating the percentage of the quality of the coefficients of the iteration within each symmetry relating to the quality labeled with "good", "neural" and "negative" associated to the percentage of improvement in approaching the target homogeneity due to the selection of the group of charges or of groups of charges to be used for each correction element and its position on the positioning grid.

18. A System for correcting inhomogeneity of the static magnetic field generated by a magnetic structure by executing the steps of the method according to one or more of claims 1 to 17, the said system comprising in combination:

a magnetic structure having at least one magnetic pole;

a positioning grid for positioning sets of correction dipoles on the said magnetic pole, the said positioning grid being placed and/or designed on the said magnetic pole having a predetermined position and orientation with respect to the said magnetic pole;

a magnetic field measuring arrangement comprising one or more magnetic field sensors which can be positioned at one or more different positions in a space permeated by the magnetic field generated by the said magnet structure, said space being optionally delimited by a virtual closed surface, such as a sphere or a spheroid;

a processing unit comprising inputs for the signals acquired by the oner or more magnetic field sensors and for the positions in the said space of the said one or more sensors corresponding univocally to each one of the signals acquired by the said sensors;

said processing unit comprising a memory in which a program is saved comprising the instructions for calculating the coefficients of a polynomial expansion, preferably of an harmonic expansion describing the magnetic field measured by the said one or more magnetic field sensors as a function of the signals acquired by the said sensors and the univocally associated position in space and which program is loadable and executable by the processor of the said processing unit;

said processing unit comprising a memory in which a program is saved comprising the instructions for calculating the coefficients of a polynomial expansion, preferably of an harmonic expansion describing a theoretical magnetic field having a predefined target homogeneity and which program is loadable and executable by the processor of the said processing unit;

said processing unit comprising a memory in which a program is stored comprising the instructions for calculating one or more alternative sets of correction dipoles, each correction dipole having a certain charge a certain sign of the charge and a certain position on the gird, which one or more sets of correction elements is calculated by applying a minimization algorithm of the differences of the coefficients of the polynomial expansion determined as a function of the measured data of the effectively generated magnetic field and the coefficients of the said polynomial expansion determined as a function of the said theoretical field having the said target homogeneity and which program is loadable and executable by the processor of the processing unit;

said processing unit comprising a memory in which a program is stored comprising the instruction for carrying out the steps of the shimming process according to one or more of the preceding claims 1 to 17 relating to a method for shimming magnets and which program is loadable and executable by the processor of the said processing unit;

said processing unit comprising a memory in which a database is loaded, the data of the said database relating to the historical data of shimming processes of magnets executed in the past and which data is structured and coadded according to the one or more of the preceding claims 1 to 17 and which database can be accessed in retrieving data and/or in storing new data by the said one or more programs which are loadable and/or executable by the processor of the said processing unit;

the system further comprising one or more output interfaces for the calculated sets of correction dipoles at each or at some of the iteration steps of the shimming process or at the final iteration step of the shimming process relatively to the number, the charge, the sign of the charge and the position on the positioning grid of the said correction dipoles, the said output interface being driven by the said processing unit;

the said output interface comprising at least one monitor in which the said data is printed in alphanumeric form and or in graphical form;

the said processing unit further comprising one or more input interfaces connected to an input of the processing unit, for inputting commands and or settings and or selections by an operator.

19. System according to claim 18, in which the said system is part of a magnetic resonance imaging apparatus

or alternatively

said system for carrying out the shimming method is preferably a device which is separated and independent from the magnetic structures to be shimmed and/or from the MRI apparatus comprising the said magnetic structures.

20. Systema according to claim 18 or 19 in which an automatic pic and place device for the correction elements is provided, such as a robotic arm, which is provided in combination with a magazine of differently magnetically charged correction elements and a control unit of the said robotic arm which controls the pic and place operations of the correction elements on the positioning grid according to the compute distribution and which control unit receives the coordinates of the position of each correction element and the information of which kind of correction element is to be put in place at a certain coordinate on the grid from the processing unit and generates the commands to drive the robotic arm.

Fig. 1A

Fig. 1B

201, 202

30

Fig. 2

Fig. 3

400

Record

MODEL          410

470
/
Metric

Choice of the symmetry section on
which carry out the shimming steps 430

Choice of the total charge by
operator                                    420

Class

POSITIVE
440

NEUTRAL
450

NEGATIVE
460

Fig. 4

Fig. 5

Processing Unit

500

Historical data DB

530

AI section 510

Applying expansion files 511

Visualizing symmetry suggested by the algorithm and choice of the symmetry 512

Guided evaluation of the solutions 513

Positioning corr. dipoles 514

Applying expansion files of step (N+1) 515

Showing the metrics 516

Display section 520

Show historical data 521

Show loaded data 522

User Interface

540

EP 4 779 346 A1

700

Correction elements magazine 707

703

S1

Fig. 6

702

706

Input and output user interface 715

Robotic arm control unit 716

Input data Position and magnetic field strength 704

Processing Unit 711

Output data Position and magnetic charge of correction elements 714

Measured data of Magnetic field 705

Memory 718 digital models of

Memory 719 digital models of magnetic structure and pole plates geometry

Data Base of historical data 708

Model generation algorithm 720

Homogeneity parameters settings 709

Constraints 713 setting data

Magnetic field homogeneity evaluator 912

Starting symmetry generator 710

Europäisches
Patentamt

European
Patent Office

Office européen
des brevets

# EUROPEAN SEARCH REPORT

**Application Number**

**EP 25 15 1902**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2023/085309 A1 (PUNZO VINCENZO [IT]) 16 March 2023 (2023-03-16) * paragraphs [0005] - [0024], [0162]; figures 5, 6, 11, 12 * ----- | 1-20 | INV. G01R33/3873 |
| A,D | EP 0 940 686 A1 (ESAOTE SPA [IT]) 8 September 1999 (1999-09-08) * the whole document * ----- | 1-20 | |

TECHNICAL FIELDS
SEARCHED        (IPC)

G01R

The present search report has been drawn up for all claims

| Place of search | Date of completion of the search | Examiner |
|---|---|---|
| Munich | 16 June 2025 | Ó Donnabháin, C |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

................................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 15 1902

This annex lists the patent family members relating to the patent documents cited in the above-mentioned European search report.
The members are as contained in the European Patent Office EDP file on
The European Patent Office is in no way liable for these particulars which are merely given for the purpose of information.

16-06-2025

| Patent document cited in search report | | Publication date | Patent family member(s) | | Publication date |
|---|---|---|---|---|---|
| US 2023085309 | A1 | 16-03-2023 | EP | 4148448 A1 | 15-03-2023 |
| | | | US | 2023085309 A1 | 16-03-2023 |
| EP 0940686 | A1 | 08-09-1999 | EP | 0940686 A1 | 08-09-1999 |
| | | | ES | 2374709 T3 | 21-02-2012 |
| | | | IT | 1305407 B1 | 04-05-2001 |
| | | | US | 6252402 B1 | 26-06-2001 |

EPO FORM P0459

For more details about this annex : see Official Journal of the European Patent Office, No. 12/82

EP 4 779 346 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0940686 A1
- EP 0940686 A
- EP 1748300 A
- US 2007229077 A
- US 2014028311 A